(19) Europäisches Patentamt
European Patent Office
Office européen des brevets

(11) **EP 3 378 663 B1**

(12) **EUROPEAN PATENT SPECIFICATION**

(45) Date of publication and mention of the grant of the patent:
**23.02.2022 Bulletin 2022/08**

(21) Application number: **18163664.8**

(22) Date of filing: **23.03.2018**

(51) International Patent Classification (IPC):
**B41M 3/00** *(2006.01)*     **B41J 11/00** *(2006.01)*
**C09D 11/037** *(2014.01)*    **C09D 11/322** *(2014.01)*
**C09D 11/38** *(2014.01)*     **B41M 3/06** *(2006.01)*
**B41M 3/16** *(2006.01)*

(52) Cooperative Patent Classification (CPC):
**B41M 3/00; B41M 3/06; C09D 11/037;**
**C09D 11/322; C09D 11/38;** B41M 3/16

(54) **THERMAL EXPANSION SHEET, MANUFACTURING METHOD FOR SHAPED OBJECT, PRINTING METHOD AND SYSTEM CONFIGURED TO MANUFACTURE A SHAPED OBJECT**

WÄRMEAUSDEHNUNGSFOLIE, HERSTELLUNGSVERFAHREN FÜR GEFORMTES OBJEKT, DRUCKVERFAHREN UND SYSTEM KONFIGURIERT ZUR HERSTELLUNG EINES GEFORMTEN OBJECTS

FEUILLE D'EXPANSION THERMIQUE, PROCÉDÉ DE FABRICATION D'UN OBJET MOULÉ, PROCÉDÉ D'IMPRESSION ET SYSTÈME CONFIGURÉ POUR LA FABRICATION D'UN OBJET MOULÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.03.2017 JP 2017059401**
           **22.02.2018 JP 2018029583**
           **08.03.2018 JP 2018041457**

(43) Date of publication of application:
**26.09.2018 Bulletin 2018/39**

(73) Proprietor: **Casio Computer Co., Ltd.**
**Tokyo 151-8543 (JP)**

(72) Inventors:
• **TAKAHASHI, Hideki**
**Tokyo 205-8555 (JP)**
• **HORIUCHI, Yuji**
**Tokyo 205-8555 (JP)**
• **MOTOYANAGI, Yoshimune**
**Tokyo 205-8555 (JP)**
• **MITSUI, Satoshi**
**Tokyo 205-8555 (JP)**

(74) Representative: **Grünecker Patent- und Rechtsanwälte**
**PartG mbB**
**Leopoldstraße 4**
**80802 München (DE)**

(56) References cited:
**EP-A1- 1 008 564**      **EP-A1- 1 790 701**
**EP-A1- 1 954 768**      **EP-A2- 0 376 322**
**WO-A1-2007/132214**    **DE-A1-102008 049 595**
**JP-A- 2004 168 842**    **JP-A- 2015 117 353**
**US-A- 5 846 622**       **US-A1- 2009 115 826**
**US-A1- 2013 161 874**

**Description**

This application relates generally to an ink, and more particularly to an ink for forming a photothermal conversion layer for causing a part or all of a thermal expansion sheet, which foams and swells in accordance with the amount of absorbed heat, to swell, a thermal expansion sheet using the ink, a manufacturing method for a shaped object, a printing apparatus, and a printing method.

<page 1a> In the related art, there are thermal expansion sheets obtained by forming a thermal expansion layer including a thermally expandable material on one surface of a base sheet. This thermally expandable material foams and swells in accordance with the amount of absorbed heat. By forming a photothermal conversion layer that converts light to heat on the thermal expansion sheet and irradiating the photothermal conversion layer with light, part or all the thermal expansion layer can be made to swell. Additionally, methods are known in the related art for forming a pseudo-three-dimensional shaped object (pseudo-three-dimensional image) on a thermal expansion sheet by changing the shape of the photothermal conversion layer (see, for example, Unexamined Japanese Patent Application Kokai Publication No. S64-28660 and Unexamined Japanese Patent Application Kokai Publication No. 2001-150812).

Photothermal conversion layers are typically formed using black ink containing carbon. However, in some cases, the black ink used to print the photothermal conversion layer affects the color of the resulting pseudo-three-dimensional image. For example, when the photothermal conversion layer is formed on the surface of a thermal expansion sheet and a color image is printed on the photothermal conversion layer using color ink, the color image may be dulled by the black ink of the photothermal conversion layer. Moreover, the color of the photothermal conversion layer appears as-is in the region of the surface of the thermal expansion sheet where the photothermal conversion layer is to be formed and swelling is intended occur.

Therefore, in order to reduce the effects of the photothermal conversion layer on the color of the pseudo-three-dimensional image (shaped object), suppression of color of the photothermal conversion layer is desired. In particular, there is a need for an ink, a thermal expansion sheet using the ink, a manufacturing method for a shaped object, a printing apparatus, and a printing method whereby a colorless transparent photothermal conversion layer having suppressed color can be formed. EP 1 790 701 A1 relates to IR-absorbing intaglio ink for an engraved steel die printing process comprising an IR absorbing material. US 2009/115826 A1 relates to a water-based ink set for inkjet recording comprising an IR absorptive ink comprising antimony-tin composite oxide fine particle and water. JP 2015 117353 A relates to an anti-counterfeit ink prepared by dispersing an anti-counterfeit ink composition containing a near-infrared absorbing material in a solvent. EP 1 008 564 A1 relates to a coating solution for forming a film for cutting off radiation which contains fine particles of at least one hexaboride and fine particles of tin-containing indium oxide or antimony-containing tin oxide. JP 2004 168842 A relates to a composition for an ink to prevent forgery containing a near infrared absorptive material comprising at least one kind of fine particles. EP 1 954 768 A1 relates to an ink having IR absorptivity comprising an IR absorptive pigment having low visible color. WO 2007/132214 A1 relates to a composition comprising an ink and IR absorbing material comprising a metal, a metal salt, a metal oxide or a metal nitride. DE 10 2008 049595 A1 relates to an IR absorbing ink containing at least one boride which absorbs radiation in the wavelength range from 800-2500 nm. EP 0 376 322 A2 relates to a three-dimensional image forming method forming a desirable image on an image recording material and applying heat selectively to the desirable image area. US 5 846 622 A relates to a heat-expandable solid pattern forming sheet comprising a base sheet, a A heat-expandable layer, a protective layer, and an adhesive layer. US 2013/161874 A1 relates to a method and apparatus for forming a three-dimensional image forming first and second print images, and forming a three-dimensional image.

In light of the state of the art, an object of this application is to provide an ink for forming a colorless transparent photothermal conversion layer, and a thermal expansion sheet, a manufacturing method for a shaped object, a printing apparatus, and a printing method using this ink.

An aspect of the present disclosure is an ink for forming a photothermal conversion layer used for causing expansion of at least a portion of a thermal expansion layer of a thermal expansion sheet. The ink includes (i) an inorganic infrared absorbing agent having a higher absorptivity in at least one region of an infrared light spectrum than in a visible light spectrum, and (ii) a base that is transparent to visible light.

An aspect of the present invention is a manufacturing method for manufacturing a shaped object by using a photothermal conversion layer for causing expansion of at least a portion of a thermal expansion layer of a thermal expansion sheet as defined in claim 1.

Another aspect of the present invention is a thermal expansion sheet as defined in claim 6.

Another aspect of the present invention is a system as defined in claim 11.

Another aspect of the present invention is a printing method for printing a photothermal conversion layer used for causing expansion of at least a portion of a thermal expansion layer of a thermal expansion sheet as defined in claim 9. Further advantageous embodiments are defined in dependent claims.

A more complete understanding of this application can be obtained when the following detailed description is considered in conjunction with the following drawings, in which:

FIG. 1 is a cross-sectional drawing illustrating a thermal expansion sheet equipped with an ink layer;

FIG. 2 is a drawing illustrating distributions of transmittance of various materials, a sunlight intensity spectrum, and a halogen lamp intensity spectrum;

FIG. 3 is a graph depicting the products of multiplying the absorptivity of cesium tungsten oxide or the absorptivity of $LaB_6$ by the radiation energy (%) from the halogen lamp at various wavelengths;

FIG. 4 is a cross-sectional view illustrating an overview of a thermal expansion sheet according to an embodiment;

FIGS. 5A to 5C are drawings illustrating an overview of a pseudo-three-dimensional image forming unit according to the embodiment;

FIG. 6 is a drawing illustrating an overview of a printing unit provided with the ink according to the embodiment;

FIG. 7 is a flowchart illustrating a pseudo-three-dimensional image forming process according to the embodiment;

FIGS. 8A to 8E are drawings illustrating the pseudo-three-dimensional image forming process according to the embodiment;

FIG. 9 is a flowchart illustrating a pseudo-three-dimensional image forming process according to a modified example;

FIGS. 10A to 10D are drawings illustrating the pseudo-three-dimensional image forming process according to the modified example;

FIG. 11A is a drawing illustrating a black density and a foaming height after printing a conventional black ink;

FIG. 11B is a drawing illustrating a black density and a foaming height after printing an ink according to Embodiment 1;

FIG. 12 is a graph illustrating pre-foaming and post-foaming color difference between a thermal expansion sheet and a photothermal conversion layer; and

FIG. 13 is a graph illustrating color difference between a thermal expansion sheet and a photothermal conversion layer before and after expansion of a thermal expansion layer according to Example 3.

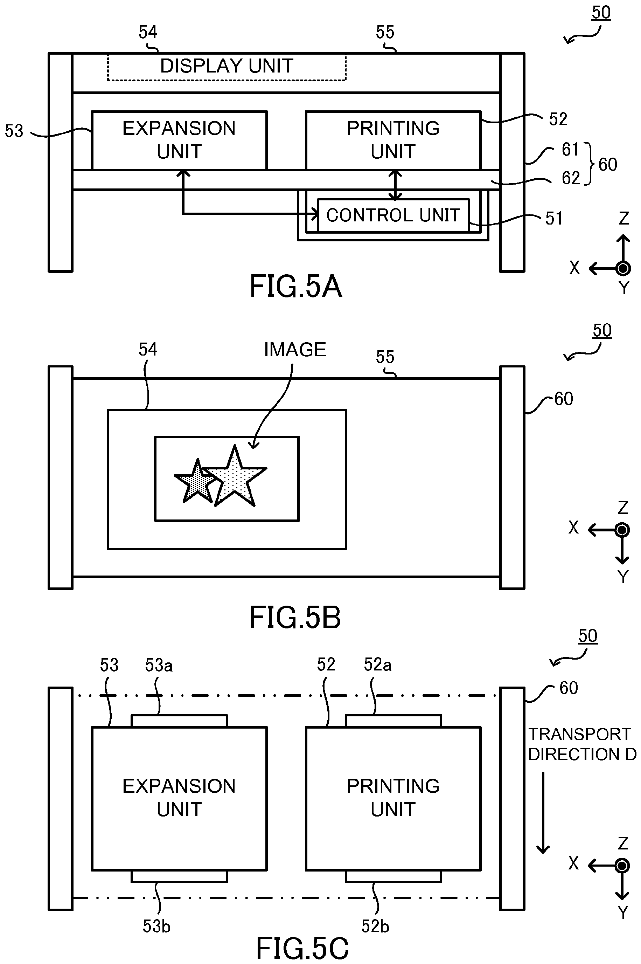

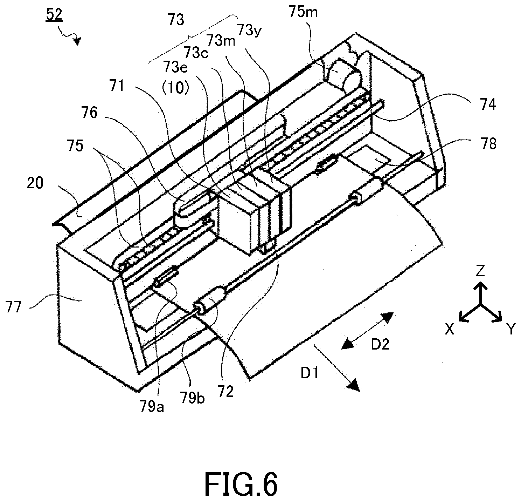

Hereinafter, a description is given of an ink, and a thermal expansion sheet, a manufacturing method for a shaped object, a printing apparatus, and a printing method using the ink according to embodiments of this application with reference to the drawings. An ink 10 as described below is an ink (referred to hereinafter as a foaming ink) for causing expansion of a thermal expansion layer. As described later, in the embodiments, a pseudo-three-dimensional image forming system 50 is used as an example of the printing apparatus. FIGS. 5A to 5C illustrate an overview of this pseudo-three-dimensional image forming system 50. A configuration in which the pseudo-three-dimensional image forming system 50 is used to form a shaped object (pseudo-three-dimensional image) having convexities and/or concavities is used as an example of the printing method. The printing unit illustrated in FIG. 6 is provided in the pseudo-three-dimensional image forming system 50, and the ink 10 of the present embodiment is set in the printing unit and used to form a photothermal conversion layer on a thermal expansion sheet 20.

In this embodiment, the shaped object is expressed on the surface of the thermal expansion sheet 20 by forming convexities and/or irregularities by the bulging of a thermal expansion layer 22. Additionally, in this application, the term "shaped object" should be interpreted broadly to include simple shapes, geometric shapes, characters, decorations, and the like. The term "decorations" refers to objects that appeal to the aesthetic sense through visual and/or tactile sensation. The term "shaped (or molded)" does not simply refer to the forming of a shaped object, but should be construed to also include concepts such as adding decorations and forming decorations. The phrase "decorative shaped object" refers to a shaped object formed as a result of adding a decoration or forming a decoration. The term "shaped object" in the present embodiment is also termed a pseudo-three-dimensional image.

The shaped object according to the present embodiments uses as a reference a particular two-dimensional face (for example, an XY plane) within a three-dimensional space, and includes unevenness (for example, a Z axis) perpendicular to the face. Such shaped object is one example of three-dimensional (3D) images, but so as to distinguish from a three-dimensional image manufactured using a so-called 3D printing technique, the shaped object is called a 2.5-dimensional (2.5D) image or a pseudo-three-dimensional (preudo-3D) image. Furthermore, the technique for manufacturing the shaped object is one example of three-dimensional image printing techniques, but so as to distinguish from a so-called 3D printer, the technique is called a 2.5-dimensional (2.5D) printing technique or a pseudo-three-dimensional (pseudo-3D) printing technique.

The expression "colorless transparent photothermal conversion layer" in the present embodiment indicates that the photothermal conversion layer of ink 10 formed on the thermal expansion sheet 20 is not visible, or indicates that the photothermal conversion layer has enough color to enable slight visibility, and additionally indicates that the color of the thermal expansion sheet 20 is not masked, or is hardly masked, by the photothermal conversion layer.

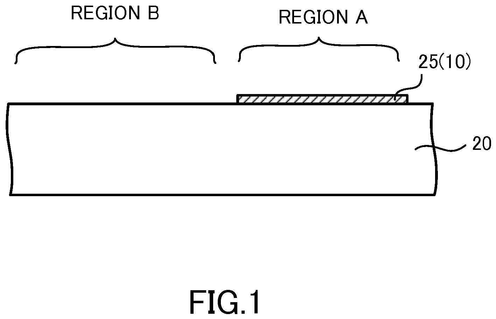

In the present embodiment, the expression "colorless transparent photothermal conversion layer" can indicate that, upon comparison between the photothermal conversion layer and the surface of a thermal expansion sheet on which no photothermal conversion layer is formed, there is no color difference, or that the color difference is extremely small. Specifically, the comparison by the color difference is performed in the following manner. As illustrated in FIG. 1, the ink 10 of the present embodiment is arranged on the thermal expansion sheet 20 and forms an ink layer 25 that corresponds to the photothermal conversion layer. A portion of the ink 10 is absorbed by the surface of the thermal expansion sheet, and although this does not result in a layer having a clearly illustrated boundary, for convenience in the description, the ink arranged on the thermal expansion sheet 20 is illustrated in the form of a layer and is termed the ink layer 25. Next, a color (of region A illustrated in FIG. 1) of the ink layer 25 and a color (of region B illustrated in FIG. 1) of the surface of the thermal expansion sheet 20 on which the ink layer 25 is not arranged are compared from above as viewed in FIG. 1. The comparison is performed for at least one of the pre-expansion thermal expansion layer 22 of the thermal expansion sheet 20 or the post-expansion thermal expansion layer 22, and at least one of these members may have no color difference or may have an extremely small color difference.

The color difference of the present embodiment may be expressed using L*a*b* color coordinates, referred to hereinafter as the Lab color coordinate system. In this case, the color of the ink layer 25 (color of the region A illustrated in FIG. 1) and the color of the surface of the thermal expansion sheet 20 where the ink layer 25 is not arranged (color of the region B illustrated in FIG. 1) are measured using a colorimeter to find numerical values of L*, a*, and b*. Thereafter, the below Equation 1 is used to calculate ΔE*ab (referred to hereinafter as ΔE) from the measured values of L*, a*, and b* of the regions A and B.

$$\Delta E^*ab = [(\Delta L^*)^2 + (\Delta a^*)^2 + (\Delta b^*)^2]^{1/2} \qquad \ldots \qquad \text{(Equation 1)}$$

ΔL* is a difference between L* of the region A and L* of the region B. Δa* and Δb* are similarly differences in the values for the region A and the region B. The "*" of the expression L*a*b* is omitted below.

Here, the expression "no color difference" in the present embodiment means that the color difference ΔE of the Lab color coordinate system is included in a range of 1.6 to 3.2 or is below this range (ΔE is less than or equal to 3.2). The ΔE range of 1.6 to 3.2 is termed an "A-grade allowable difference", is a color difference of a level that would be hardly noticed during side-by-side comparison of color, and is a color difference of a level that the colors would be generally considered to be the same color. The color difference ΔE is further preferably included in or below the range of 0.8 to 1.6. The ΔE range of 0.8 to 1.6 is termed an "AA-grade allowable difference", and is a color difference of a level that would be slightly noticed during side-by-side comparison of color.

Further, the ink 10 according to this embodiment includes an inorganic infrared absorbing agent and, in addition thereto, may include any or all of ingredients selected from a solvent (water or organic solvent), a coloring agent (dye or pigment), a dispersant, a penetrant, an anti-drying agent, a pH adjuster, a preservative, a surfactant, a coloring agent (dye or pigment), a resin, and the like. The ink 10 may include other ingredients.

In a specific example in which the ink 10 is a water-based ink, the ink 10 includes an inorganic infrared absorbing agent, water, and an aqueous organic solvent. The aqueous organic solvent is not particularly limited, and examples thereof include polyalkylene glycols such as polyethylene glycol and polypropylene glycol; alkylene glycols such as ethylene glycol and triethylene glycol; glycerin; glycerols; lower alkyl ethers of polyhydric alcohols such as triethylene glycol monobutyl ether, ethylene glycol methyl (ethyl) ether, and diethylene glycol methyl (ethyl) ether; N-methyl-2-pyrrolidone; 1,3-dimethyl-2-imidazolidinone; ethanol; and isopropanol. These aqueous organic solvents are included in the ink 10 as the humectant, surfactant, and the like. Additionally, the ink 10 may include triethanolamine as the pH adjuster, and may also include other additives.

The ink 10 of the present embodiment is characterized as being transparent to visible light (hereinafter simply referred to as "transparent") in a state in which an inorganic infrared absorbing agent is not intermixed. That is to say, the base of the ink 10 is characterized as being transparent. If a coloring agent is added to the ink 10, the ink 10 is characterized as being transparent in the state in which the inorganic infrared absorbing agent and the coloring agent are not included.

The expression "the ink 10 (base of the ink 10) not including the inorganic infrared absorbing agent is transparent" indicates that, whether the base of the ink 10 is printed on a black sheet or is printed on a white sheet, the color of the base material sheet is not masked or is hardly masked by the layer formed by the ink, and indicates that the color of the base material sheet can be visually recognized.

In one example, the ink 10 of this embodiment is used in the inkjet printing unit 52 illustrated in FIG. 6. Specifically, the ink 10 is loaded into a cartridge and, as illustrated in FIG. 6, the cartridge is set in the printing unit 52.

As long as the formed photothermal conversion layer is colorless and transparent, the ink 10 may optionally include a coloring agent. For example, with an objective such as adjusting color of the ink 10 in order to approach the color of the surface of the thermal expansion sheet 20, the ink 10 may include the coloring agent. No particular limitation is placed on the color of the coloring agent. The color of the coloring agent may be appropriately selected from yellow, cyan, magenta, or any other freely-selected color. Moreover, as long as the photothermal conversion layer is colorless and transparent, the density of the coloring agent in the ink 10 is not particularly limited.

An inorganic material is used as the inorganic infrared absorbing agent. This inorganic material has higher absorptivity of light (absorptivity) in at least one region of the infrared light spectrum than in the visible light spectrum. In particular, the inorganic infrared absorbing agent preferably has a higher absorptivity of light in the near-infrared region than in the visible light spectrum. The visible light transparency of the ink 10 can be improved and the color of the ink 10 can be suppressed by selecting a material for which light transmittance (low absorptivity) in the visible light spectrum is high. By using a photothermal conversion layer printed using the ink 10, blurring of the color of the color ink layer can be prevented compared to when using traditional carbon-containing inks. Further, a colorless transparent photothermal conversion layer can be formed.

In this embodiment, examples of the inorganic infrared absorbing agent include metal oxides, metal borides, and metal nitrides.

Specific examples of the metal oxides include tungsten oxide compounds, indium oxide, indium tin oxide (ITO), antimony tin oxide (ATO), titanium oxide, zirconium oxide, tantalum oxide, cesium oxide, and zinc oxide.

A metal multi-boride compound is preferable and a metal hexaboride compound is particularly preferable as the metal boride, and one or a plurality of materials selected from the group consisting of lanthanum hexaboride ($LaB_6$), cerium hexaboride ($CeB_6$), praseodymium hexaboride ($PrB_6$), neodymium hexaboride ($NdB_6$), gadolinium hexaboride ($GdB_6$), terbium hexaboride ($TbB_6$), dysprosium hexaboride ($DyB_6$), holmium hexaboride ($HoB_6$), yttrium hexaboride ($YB_6$), samarium hexaboride ($SmB_6$), europium hexaboride ($EuB_6$), erbium hexaboride ($ErB_6$), thulium hexaboride ($TmB_6$), ytterbium hexaboride ($YbB_6$), lutetium hexaboride ($LuB_6$), lanthanum hexaboride cerium (($La, Ce)B_6$), strontium hexaboride ($SrB_6$), calcium hexaboride ($CaB_6$), or the like can be used as the metal boride.

Examples of the metal nitrides include titanium nitride, niobium nitride, tantalum nitride, zirconium nitride, hafnium nitride, and vanadium nitride.

The tungsten oxide compound is expressed by the following formula:

$$MxWyOz ... \qquad (I)$$

Here, element M is at least one element selected from the group consisting of Cs, Rb, K, Tl, In, Ba, Li, Ca, Sr, Fe, and Sn, W is tungsten, and O is oxygen.

The value of x/y preferably satisfies the relationship $0.001 \leq x/y \leq 1.1$, and x/y is particularly preferably in the vicinity of 0.33. Additionally, i the value of z/y preferably satisfies the relationship $2.2 \leq z/y \leq 3.0$. Specific examples of the formula of the tungsten oxide compound include $Cs_{0.33}WO_3$, $Rb_{0.33}WO_3$, $K_{0.33}WO_3$, and $Tl_{0.33}WO_3$.

Of the examples of the inorganic infrared absorbing agent described above, the metal hexaboride compound or the tungsten oxide compound is preferable, and the lanthanum hexaboride ($LaB_6$) or cesium tungsten oxide are particularly preferable from the perspectives of obtaining high light absorptivity (low light transmittance) in the near-infrared region and high transmittance in the visible light spectrum. Any one of the inorganic infrared absorbing agents described above may be used alone, or a combination of two or more different materials may be used.

While not particularly limited thereto, the ink 10 of this embodiment includes the inorganic infrared absorbing agent at a concentration of 20 wt.% to 0.10 wt.%.

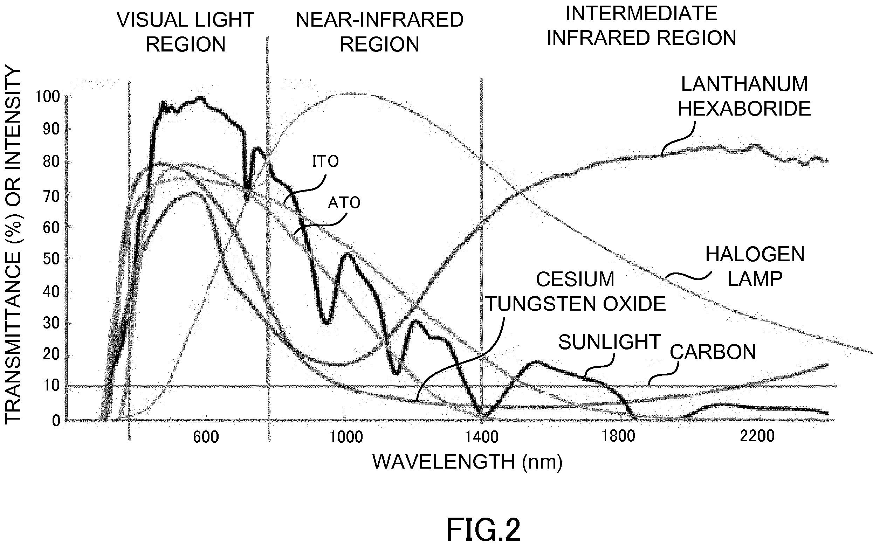

FIG. 2 illustrates distributions of the light transmittance of carbon, ITO, ATO, cesium tungsten oxide, and $LaB_6$, the sunlight intensity spectrum, and the spectral distribution of a halogen lamp. In FIG. 2, the sunlight intensity spectrum and the spectral distribution of the halogen lamp each have intensities that peak at 100. As illustrated in FIG. 2, the carbon traditionally used to form photothermal conversion layers displays substantially constant transmittance in various wavelength ranges. Carbon has low transmittance (high absorptivity) and exhibits a black color in the visible light spectrum. In contrast, ITO and ATO, which are examples of the metal oxide, have remarkably high transmittance in the visible light spectrum. In addition, ITO and ATO display lower transmittance in the near-infrared region and even lower transmittance (high absorptivity) in the intermediate infrared region than in the visible light spectrum. Furthermore, the cesium tungsten oxide, which is an example of the tungsten oxide compound, displays lower transmittance in the near-infrared region than in the visible light spectrum. Moreover, the lanthanum hexaboride, which is an example of the metal hexaboride compound, displays lower transmittance in the near-infrared region of the infrared spectrum than in the visible light spectrum.

FIG. 2 also depicts the spectral distribution of the halogen light used as an irradiating unit. Light irradiated from the halogen lamp displays high intensity, particularly in the near-infrared region. The cesium tungsten oxide and the lanthanum hexaboride depicted in FIG. 2 have low transmittance and display high absorptivity in the near-infrared region, where the light irradiated from the halogen lamp displays high intensity. As such, when the halogen lamp is used as the irradiating unit, cesium tungsten oxide or the $LaB_6$ are preferably used because light will be absorbed with particularly high efficiency in the near-infrared region, where the light irradiated from the halogen lamp displays high intensity. In addition, provided that high absorptivity in the near-infrared region is displayed, a material other than the cesium tungsten oxide and the lanthanum hexaboride may be used.

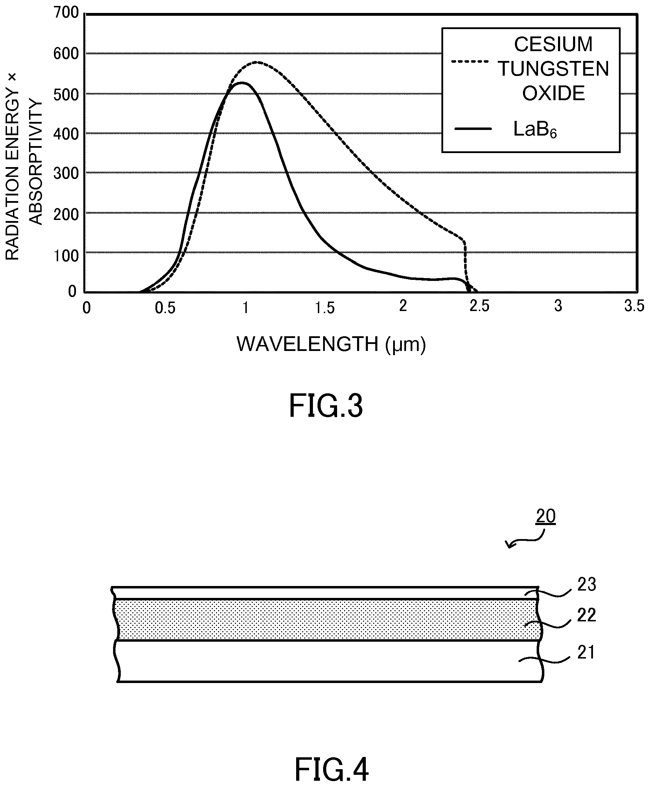

FIG. 3 is a graph depicting the products of multiplying the absorptivity of cesium tungsten oxide or the absorptivity of $LaB_6$ by the radiation energy (%) from the halogen lamp at various wavelengths. Here, the ratio (%) of radiation energy at a temperature (2900K) to black-body radiation (peak normalized at 100%) at a reference temperature (2000K) is used as the radiation energy (%). Cesium tungsten oxide is clearly capable of excellent energy absorption, particularly in the near-infrared region and intermediate infrared region.

Values obtained by integrating the graph by wavelength correspond to amounts of energy absorbable by cesium tungsten oxide and the $LaB_6$. Accordingly, provided that the foaming height of the thermally expandable material is not saturated, the ratio of these integral values is proportional to the foaming height. Specifically, the ratio of integral values of cesium tungsten oxide: $LaB_6$ is 1:0.58. Thus, the foaming height obtainable in a photothermal conversion layer using $LaB_6$ is about 0.58 times greater than the foaming height obtainable in a photothermal conversion layer using cesium tungsten oxide.

Next, the thermal expansion sheet 20, on which the photothermal conversion layer is to be formed by the ink 10, of this embodiment is described with reference to the drawings. As illustrated in FIG. 4, the thermal expansion sheet 20 includes a base material 21, a thermal expansion layer 22, and an ink receiving layer 23. While described in detail later, the thermal expansion sheet 20 is subjected to printing by the pseudo-three-dimensional image forming system 50 outlined in FIGS. 5A to 5C. As a result of the printing, a shaped object (pseudo-three-dimensional image) having convexities and/or concavities is formed.

The base material 21 is implemented as a sheet-like member (including films). The base material 21 supports the thermal expansion layer 22 and the like. Examples of the base material 21 include paper such as high-quality paper, and commonly used plastic film such as polypropylene, polyethylene terephthalate (PET), and polybutylene terephthalate (PBT). Additionally, fabric or the like may be used as the base material 21. The base material 21 has sufficient strength so that, when part or all of the thermal expansion layer 22 swells due to foaming, the opposite side (lower side as illustrated in FIG. 4) of the base material 21 does not bulge, and wrinkles, waves, and the like do not form. The base material 21 also has heat resistance sufficient to resist heating carried out to foam the thermal expansion layer 22.

The thermal expansion layer 22 is formed on a first face (the upper face illustrated in FIG. 4) of the base material 21. The thermal expansion layer 22 is a layer that swells to a size in accordance with heating temperature and heating time, and includes a plurality of thermally expandable materials (thermally expandable microcapsules, microcapsules) dispersed/disposed therethroughout. While described in detail later, in this embodiment, a photothermal conversion layer is formed on the ink receiving layer 23 provided on the upper face (surface) of the base material 21 and/or on the lower face (back face) of the base material 21. The regions where the photothermal conversion layer is provided are heated by irradiating the photothermal conversion layer with light. The thermal expansion layer 22 absorbs the heat generated by the photothermal conversion layer provided on the surface and/or back face of the thermal expansion sheet 20, foams, and swells. The causing of the thermal expansion sheet 20 to swell may be selectively limited to only specific regions.

A thermoplastic resin selected from vinyl acetate polymers, acrylic polymers, and the like is used as a binder. The thermally expandable microcapsules include propane, butane, or a similar low boiling point volatile substance encapsulated in thermoplastic resin shells. The shells are formed from a thermoplastic resin selected from, for example, polystyrene, polyvinyl chloride, polyvinylidene chloride, polyvinyl acetate, polyacrylic acid ester, polyacrylonitrile, polybutadiene, and copolymers thereof. An average particle size of the thermally expandable microcapsules is about 5 to 50 $\mu$m. When these microcapsules are heated to a thermal expansion start temperature or higher, the polymer shells that are made from the resin soften and the low boiling point volatile substance encapsulated therein vaporizes. The pressure resulting from this vaporization causes the capsules to swell. While dependent on the characteristics of the microcapsules to be used, the microcapsules swell to a size about five-times larger than that prior to swelling.

The ink receiving layer 23 is formed on the thermal expansion layer 22. The ink receiving layer 23 receives and holds ink used in a printing process, such as the ink of an inkjet printer. The ink receiving layer 23 is formed using a commonly used material in accordance with the ink to be used in the printing process. In an example in which water-based ink is used, the ink receiving layer 23 is formed using a material selected from porous silica, polyvinyl alcohol (PVA), or the like. Additionally, when the photothermal conversion layer is to be formed on the back face of the base material 21 as well, an ink receiving layer may also be formed on the back face of the base material 21. Further, depending on the type of the ink 10, the ink receiving layer 23 may be omitted. Thus in the case in which the ink receiving layer 23 is not formed, the ink layer 25 (photothermal conversion layer) is formed on the thermal expansion layer 22.

Pseudo-Three-Dimensional (Pseudo-3D) Image Forming System

Next, the pseudo-three-dimensional image forming system 50 that performs the printing on the thermal expansion sheet 20 to form a pseudo-three-dimensional image is described. As illustrated in FIGS. 5A to 5C, the pseudo-three-dimensional image forming system 50 includes a control unit 51, a printing unit 52, an expansion unit 53, a display unit 54, a top panel 55, and a frame 60. FIG. 5A is a front view of the pseudo-three-dimensional image forming system 50; FIG. 5B is a plan view of the pseudo-three-dimensional image forming system 50 with the top panel 55 closed; and FIG. 5C is a plan view of the pseudo-three-dimensional image forming system 50 with the top panel 55 open. In FIGS. 5A to 5C, the X-direction is the same as the horizontal direction, the Y-direction is the same as a transport direction D in which the sheet is transported, and the Z-direction is the same as the vertical direction. The X-direction, the Y-direction, and the Z-direction are orthogonal to each other.

The control unit 51, the printing unit 52, and the expansion unit 53 are each mounted in the frame 60 as illustrated in FIG. 5A. Specifically, the frame 60 includes a pair of substantially rectangular side face panels 61 and a connecting beam 62 provided between the side face panels 61. The top panel 55 spans between upper portions of the side face panels 61. The printing unit 52 and the expansion unit 53 are disposed side-by-side in the X-direction on the connecting beam 62 that spans between the side face panels 61, and the control unit 51 is fixed below the connecting beam 62. The display unit 54 is embedded in the top panel 55 so as to be flush with the upper face of the top panel 55.

The control unit 51 includes a central processing unit (CPU), a read only memory (ROM), a random access memory (RAM), and the like, and controls the printing unit 52, the expansion unit 53, and the display unit 54.

The printing unit 52 is an inkjet printing apparatus. As illustrated in FIG. 5C, the printing unit 52 includes a loading section 52a for receiving the thermal expansion sheet 20, and a discharge section 52b for discharging the thermal expansion sheet 20. The printing unit 52 prints a designated image on the front face or the back face of the thermal expansion sheet 20 received through the loading section 52a, and discharges the thermal expansion sheet 20 on which the image has been printed through the discharge section 52b. Additionally, the printing unit 52 includes color ink (cyan (C), magenta (M), and yellow (Y)) for forming a color ink layer 42 (described later), and the ink 10 for forming a front side photothermal conversion layer 41 and a back side photothermal conversion layer 43. Note that the printing unit 52 may also include a black color ink free of carbon black as color ink for forming black or gray color in the color ink layer 42.

The printing unit 52 acquires from the control unit 51 color image data representing a color image (color ink layer 42) to be printed on the front face of the thermal expansion sheet 20, and prints the color image (color ink layer 42) using the color ink (cyan, magenta, and yellow) on the basis of the color image data. Black or gray color in the color ink layer is formed by blending the three CMY colors or by using a black color ink free of carbon black.

The printing unit 52 prints the front side photothermal conversion layer 41 on the basis of front face foaming data using the ink 10. This front face foaming data is data that indicates the portion of the front face of the thermal expansion sheet 20 to be foamed and caused to swell. Likewise, the printing unit 52 prints the back side photothermal conversion layer 43 on the basis of back face foaming data using the ink 10. This back face foaming data is data that indicates the portion of the back face of the thermal expansion sheet 20 to be foamed and caused to swell. The swelling height of the thermal expansion layer 22 corresponds to the density of the ink 10, and greater densities lead to greater swelling heights. As such, the shade of the ink 10 is determined by area coverage modulation or a similar technique such that the density of the ink 10 corresponds to the target height.

FIG. 6 illustrates a detailed configuration of the printing unit 52. As illustrated in FIG. 6, the printing unit 52 includes a carriage 71 capable of reciprocating movement in a main scanning direction D2 (the X-direction), which is orthogonal to a sub-scanning direction D1 (the Y-direction). The sub-scanning direction D1 is the direction in which the thermal expansion sheet 20 is transported.

A print head 72 that executes the printing and ink cartridges 73 (73e, 73c, 73m, and 73y) containing ink are attached to the carriage 71. The ink cartridges 73e, 73c, 73m, and 73y respectively contain the ink 10 of this embodiment, and cyan (C), magenta (M), and yellow (Y) color ink. Each ink is discharged from a corresponding nozzle of the print head 72.

The carriage 71 is supported slidably on a guide rail 74, and is sandwiched between drive belts 75. The drive belts 75 are driven by the rotation of a motor 75m and, as a result, the carriage 71 moves in the main scanning direction D2 together with the print head 72 and the ink cartridges 73.

A platen 78 is provided in a lower portion of the frame 60, at a position facing the print head 72. The platen 78 extends in the main scanning direction D2 and constitutes a portion of a transport path of the thermal expansion sheet 20. A pair of feed rollers 79a (lower roller not illustrated in the drawings) and a pair of discharge rollers 79b (lower roller not illustrated in the drawings) are provided in the transport path of the thermal expansion sheet 20. The pair of feed rollers 79a and the pair of discharge rollers 79b transport the thermal expansion sheet 20 in the sub-scanning direction D1. Here, the thermal expansion sheet 20 is supported on the platen 78.

The printing unit 52 is connected to the control unit 51 via a flexible communication cable 76. The control unit 51 controls the print head 72, the motor 75m, the pair of feed rollers 79a, and the pair of discharge rollers 79b via the flexible communication cable 76. Specifically, the control unit 51 controls the pair of feed rollers 79a and the pair of discharge rollers 79b to transport the thermal expansion sheet 20. Additionally, the control unit 51 causes the motor 75m to rotate, thereby moving the carriage 71 and transporting the print head 72 to an appropriate position in the main scanning direction D2.

The expansion unit 53 applies heat to the thermal expansion sheet 20 to cause the thermal expansion sheet 20 to swell. As illustrated in FIG. 5C, the expansion unit 53 includes an loading section 53a for loading the thermal expansion sheet 20, and a discharge section 53b for discharging the thermal expansion sheet 20. The expansion unit 53 transports the thermal expansion sheet 20 loaded through the loading section 53a and, at the same time, applies heat to the thermal expansion sheet 20, thereby causing the thermal expansion sheet 20 to swell. An irradiating unit (not illustrated in the drawings) is provided in the expansion unit 53. The irradiating unit is fixed within the expansion unit 53. The thermal expansion sheet 20 is moved at a constant speed past the vicinity of the irradiating unit and, as a result, the entire thermal expansion sheet 20 is heated. Note that, when printing the ink 10 at a low density to make the photothermal conversion layer less conspicuous, the target swelling height can still be obtained by reducing the transport speed and lengthening the amount of time that the thermal expansion sheet 20 is irradiated with the light.

In one example, the irradiating unit is a halogen lamp that irradiates, at the thermal expansion sheet 20, light in the near-infrared region (750 to 1400 nm wavelength range), the visible light spectrum (380 to 750 nm wavelength range), or the intermediate infrared region (1400 to 4000 nm wayelength range). The wavelength of the light irradiated from the halogen lamp has the characteristics illustrated in FIG. 2. Specifically, the halogen lamp irradiates light of particularly high intensity in the near-infrared region. Using a material having higher absorptivity in the near-infrared region than in the visible light spectrum is as the inorganic infrared absorbing agent included in the ink 10 of this embodiment if preferable because the wavelength range displaying high intensity of the halogen lamp and the wavelength range displaying efficient absorptivity of the inorganic infrared absorbing agent will match. In addition to the halogen lamp, a xenon lamp or the like may also be used as the irradiating unit. In this case, a material having high absorptivity in the wavelength range where the emission intensity of the lamp is high is preferably used as the inorganic infrared absorbing agent. Additionally, light is converted to heat more efficiently in the regions where the photothermal conversion layer is printed than in regions where the photothermal conversion layer is not printed. As such, the region of the thermal expansion layer 22 where the photothermal conversion layer is printed is primarily heated and, as a result, the region of the thermal expansion layer 22 where the photothermal conversion layer is printed swells.

The display unit 54 is implemented as a touch panel or the like. In the example illustrated in FIG. 5B, the display unit 54 displays an image (the stars illustrated in FIG. 5B) printed on the thermal expansion sheet 20 by the printing unit 52. Additionally, the display unit 54 displays operating instructions or the like, and a user can operate the pseudo-three-dimensional image forming system 50 by touching the display unit 54.

Pseudo-Three-Dimensional (Pseudo-3D) Image Forming Processing

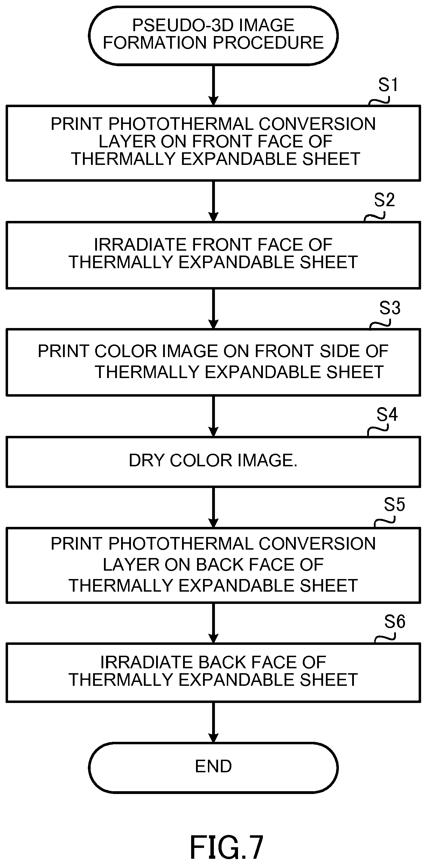

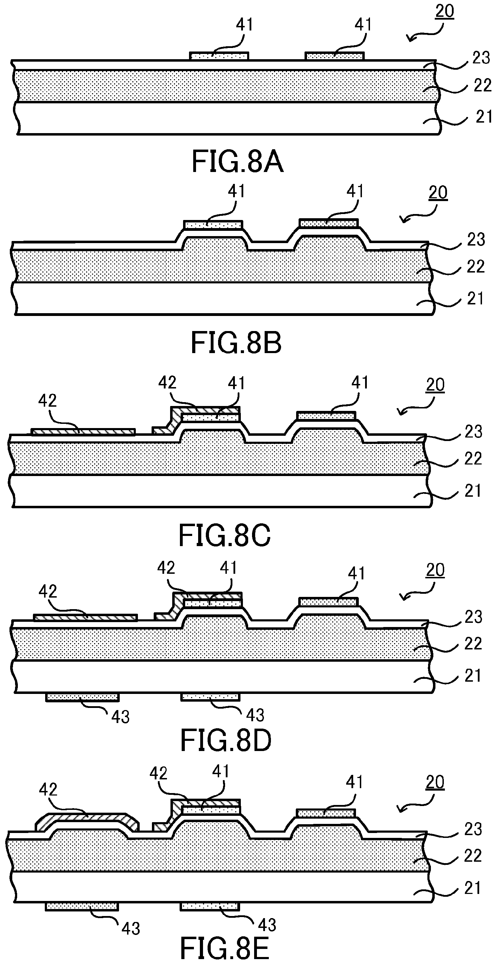

Next, an explanation is given of the flow of processing whereby a pseudo-three-dimensional image is formed on the thermal expansion sheet 20 by the pseudo-three-dimensional image forming system 50, while referencing the flowchart illustrated in FIG. 7, and the cross-sectional views of the thermal expansion sheet 20 illustrated in FIGS. 8A to 8E. Since the shaped object is manufactured by the pseudo-three-dimensional image forming processing, the pseudo-three-dimensional image forming processing is also a manufacturing method for the shaped object.

First, a user prepares a thermal expansion sheet 20 on which a pseudo-three-dimensional image has not been formed, and designates the color image data, the front face foaming data, and the back face foaming data using the display unit 54. Then, the user inserts the thermal expansion sheet 20 into the printing unit 52 with the front face facing upward. The printing unit 52 prints a photothermal conversion layer (the front side photothermal conversion layer 41) on the front face of the inserted thermal expansion sheet 20 (step S1). The front side photothermal conversion layer 41 is formed by the ink 10 described above. The printing unit 52 discharges the ink 10 of this embodiment onto the front face of the thermal expansion sheet 20 in accordance with the designated front face foaming data. As a result, the front side photothermal conversion layer 41 is formed on the ink receiving layer 23, as illustrated in FIG. 8A. Note that, to facilitate comprehension, an example is illustrated in which the front side photothermal conversion layer 41 is formed on the ink receiving layer 23 but, more accurately, the ink 10 is received into the ink receiving layer 23 and, as such, the front side photothermal conversion layer 41 is formed in the ink receiving layer 23.

Second, the user inserts the thermal expansion sheet 20 onto which the front side photothermal conversion layer 41 has been printed into the expansion unit 53 with the front face facing upward. The expansion unit 53 heats the inserted thermal expansion sheet 20 from the front face (step S2). Specifically, the irradiating unit of the expansion unit 53 irradiates light onto the front face of the thermal expansion sheet 20. The front side photothermal conversion layer 41 printed on the front face of the thermal expansion sheet 20 absorbs the irradiated light, thereby generating heat. As a result, as illustrated in FIG. 8B, the region of the thermal expansion sheet 20 where the front side photothermal conversion layer 41 was printed bulges and swells. In FIG. 8B, when the density of the ink 10 is higher in the front side photothermal conversion layer 41 on the right side than in the front side photothermal conversion layer 41 on the left side, the region printed at the higher density can be made to bulge higher, as illustrated in FIG. 8B.

Third, the user inserts the thermal expansion sheet 20, for which the front face has been heated and caused to swell, into the printing unit 52 with the front face facing upward. The printing unit 52 prints a color image (the color ink layer 42) on the front face of the inserted thermal expansion sheet 20 (step S3). Specifically, the printing unit 52 discharges the various cyan (C), magenta (M), and yellow (Y) inks onto the front face of the thermal expansion sheet 20 in accordance with the designated color image data. As a result, the color ink layer 42 is formed on the ink receiving layer 23 and the front side photothermal conversion layer 41, as illustrated in FIG. 8C.

Fourth, the user inserts the thermal expansion sheet 20, onto which the color ink layer 42 has been printed, into the expansion unit 53 with the back face facing upward. The expansion unit 53 heats the inserted thermal expansion sheet 20 from the back face, and dries the color ink layer 42 formed on the front face of the thermal expansion sheet 20 (step S4). Specifically, the irradiating unit of the expansion unit 53 irradiates light onto the back face of the thermal expansion sheet 20, thereby heating the color ink layer 42 and volatilizing the solvent included in the color ink layer 42.

Fifth, the user inserts the thermal expansion sheet 20, onto which the color ink layer 42 has been printed, into the printing unit 52 with the back face facing upward. The printing unit 52 prints a photothermal conversion layer (the back side photothermal conversion layer 43) on the back face of the inserted thermal expansion sheet 20 (step S5). The back side photothermal conversion layer 43 is formed by the ink 10 of this embodiment in the same manner as the front side photothermal conversion layer 41 printed on the front face of the thermal expansion sheet 20. The printing unit 52 discharges the ink 10 onto the back face of the thermal expansion sheet 20 in accordance with the designated back face foaming data. As a result, the back side photothermal conversion layer 43 is formed on the back face of the base material 21, as illustrated in FIG. 8D. For the back side photothermal conversion layer 43 as well, as illustrated in FIG. 8D, when the density of the ink 10 is higher in the back side photothermal conversion layer 43 on the left side than in the back side photothermal conversion layer 43 on the right side, the region printed at the higher density can be made to bulge higher.

Sixth, the user inserts the thermal expansion sheet 20, onto which the back side photothermal conversion layer 43 has been printed, into the expansion unit 53 with the back face facing upward. The expansion unit 53 heats the inserted thermal expansion sheet 20 from the back face (step S6). Specifically, the irradiating unit (not illustrated in the drawings) of the expansion unit 53 irradiates light onto the back face of the thermal expansion sheet 20. The back side photothermal conversion layer 43 printed on the back face of the thermal expansion sheet 20 absorbs the irradiated light, thereby generating heat. As a result, as illustrated in FIG. 8E, the region of the thermal expansion sheet 20 where the back side photothermal conversion layer 43 was printed bulges and swells.

The pseudo-three-dimensional image is formed in the thermal expansion sheet 20 as a result of carrying out the procedures described above.

The ink 10 of this embodiment includes the inorganic infrared absorbing agent demonstrating higher absorptivity in at least one wavelength region of the infrared spectrum than in the visible light spectrum and, as a result, enables making of the formed photothermal conversion layer colorless and transparent. Thus a thermal expansion layer can be provided that has the colorless transparent photothermal conversion layer. By using the ink 10 of this embodiment, an ink, a printing apparatus, a printing method, and a manufacturing method for a shaped object can be provided that enable printing of a photothermal conversion layer that is colorless and transparent and thus has a greatly reduced effect of color on the pseudo-three-dimensional image.

Modified Example of Pseudo-Three-Dimensiona! (Pseudo-3D) Image Forming Processing

The pseudo-three-dimensional image forming processing is not limited to the process order illustrated in FIG. 7, and the order of the steps may be rearranged as detailed hereinafter.

For ease of description, the steps illustrated in FIG. 7 are referred to as follows: the step of forming the front side photothermal conversion layer 41 (hereinafter referred to as "front side conversion layer") on the front side (the upper face in FIG. 4) of the thermal expansion sheet 20 (step S1 in FIG. 7) is referred to as a front side conversion layer forming step; the step of irradiating electromagnetic waves (light) onto the front side of the thermal expansion sheet 20 and causing the thermal expansion layer 22 to swell (step S2 in FIG. 7) is referred to as a front side swelling step; the step of printing the color image on the front side of the thermal expansion sheet 20 (step S3 in FIG. 7) is referred to as a color printing step; the step of forming the back side photothermal conversion layer 43 (hereinafter referred to as "back side conversion layer") on the back side (the lower face in FIG. 4) of the thermal expansion sheet 20 (step S5 in FIG. 7) is referred to as a back side conversion layer forming step; and the step of irradiated electromagnetic waves onto the back side of the thermal expansion sheet 20 and causing the thermal expansion layer 22 to swell (step S6 in FIG. 7) is referred to as a back side swelling step. While the color ink is dried with the back face of the sheet facing upward in the step of drying the color ink (step S4) illustrated in FIG. 7, but the orientation of the thermal expansion sheet 20 is not limited to this orientation. In both the examples given below, the drying step may be carried out with the front face of the thermal expansion sheet 20 facing upward. In the drying step, whether the front face or the back face is faced upwards is determined on the basis of factors such as which face the conversion layer is formed on and whether the thermal expansion layer 22 is not to be further deformed in the drying step. Additionally, in both of the embodiments given below, the drying step (step S4) may be omitted, depending on the order in which the steps are executed.

For embodiment, the pseudo-three-dimensional image forming processing is not limited to the process order illustrated in FIG. 7, and the back side conversion layer may be formed first. Specifically, the back side conversion layer forming step is performed first, then the back side swelling step is performed, and thereafter, the front side conversion layer forming step is performed. In this case, in terms of the flowchart illustrated in FIG. 7, step S5 and step S6 are executed, and then steps S1 to S4 are executed. Additionally, since the back side conversion layer is already formed at the stage when step S4 is executed, the drying step is preferably carried out with the front face of the sheet facing upward in step S4. Moreover, after all of the steps for causing the thermal expansion layer to swell have been completed, a color image may be printed. In this case, the front side conversion layer forming step, the front side swelling step, the back side conversion layer forming step, and the back side swelling step are sequentially performed, and then the color printing step is performed. That is, in terms of FIG. 7, step S1 and step S2 are executed, then step S5 and step S6 are executed, and then step S3 and step S4 are executed. Note that step S4 may be omitted. Performing the back side conversion layer forming step and the back side swelling step first is possible and, in this case, step S5 and step S6 are executed and then steps S1 to S4 are executed. In this case as well, step S4 may be omitted.

The color printing step can also be performed prior to the front side conversion layer forming step and other steps. This is because the color of the ink 10 of this embodiment is particularly suppressed and, as such, the influence of the photothermal conversion layer on the color of the color layer can be suppressed even when the photothermal conversion layer is formed on the color image. In such cases, the color printing step, the drying step, the front side conversion layer forming step, and the front side swelling step are sequentially performed, and the back side conversion layer forming step and the back side swelling step are performed. In terms of the flowchart illustrated in FIG. 7, step S3 and step S4, then step S1 and step S2, and then step S5 and step S6 are sequentially executed. Note that, in step S4, the drying step may be carried out with the front face of the sheet facing upward. Alternatively, the back side conversion layer forming step may be performed first and, in this case, steps S3 to S6 are sequentially executed and, thereafter, step S1 and step S2 are executed. Note that the drying in step S4 may be carried out with the front face of the sheet facing upward.

The color printing step and the front side conversion layer forming step may be combined to print the color ink layer and the front side conversion layer in a single step. In this embodiment, the color ink layer and the front side conversion layer are printed simultaneously.

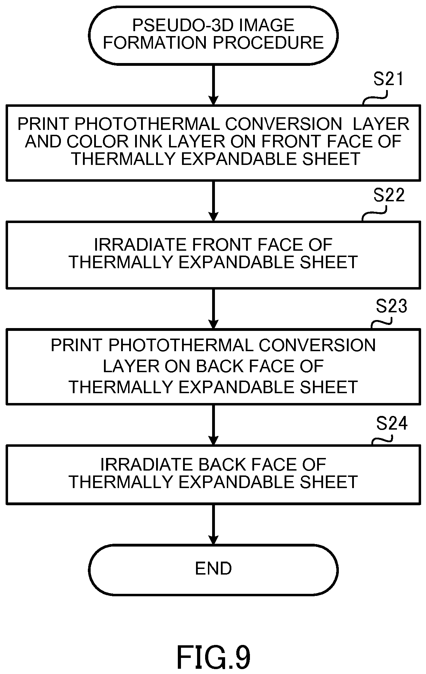

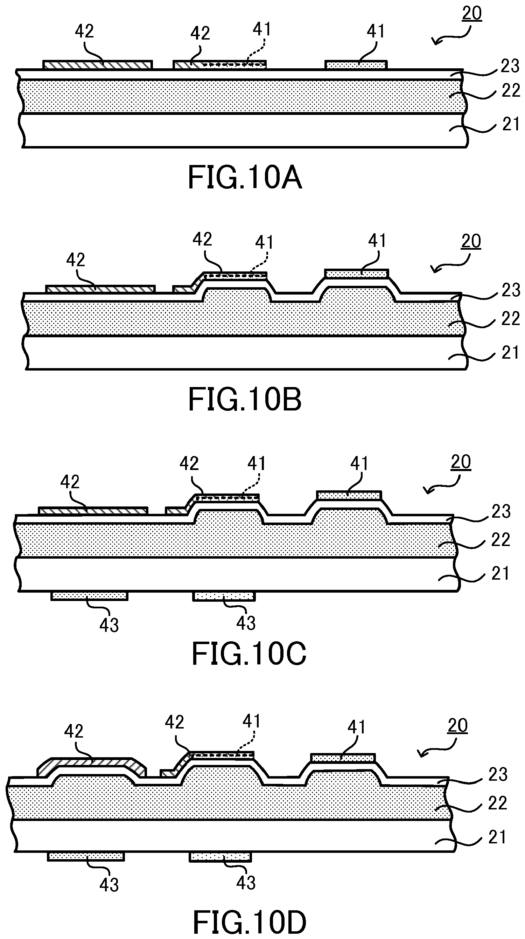

Next, an explanation will be given of the flow of processing whereby a pseudo-three-dimensional image is formed on the thermal expansion sheet 20 by the pseudo-three-dimensional image forming system 50, while referencing the flowchart illustrated in FIG. 9, and the cross-sectional views of the thermal expansion sheet 20 illustrated in FIGS. 10A to 10D. In this modified example, as illustrated in FIG. 6, the color ink for printing the color image and the ink 10 for forming the photothermal conversion layer are set in the printing unit 52. The printing unit 52 prints the front side photothermal conversion layer 41 on the basis of the front face foaming data using the ink 10. This front face foaming data is data that indicates the portion of the front face of the thermal expansion sheet 20 to be foamed and caused to swell. Likewise, the printing unit 52 prints the back side photothermal conversion layer 43 on the basis of the back face foaming data using the ink 10. This back face foaming data is data that indicates the portion of the back face of the thermal expansion sheet 20 to be foamed and caused to swell.

First, a user prepares a thermal expansion sheet 20 on which a pseudo-three-dimensional image has not been formed, and designates the color image data, the front face foaming data, and the back face foaming data using the display unit 54. Then the user inserts the thermal expansion sheet 20 into the printing unit 52 with the front face facing upward. Next, the printing unit 52 prints the front side conversion layer (the front side photothermal conversion layer) 41 and the color image (the color ink layer 42) on the front face of the inserted thermal expansion sheet 20 (step S21). Specifically, the printing unit 52 discharges, on the front face of the thermal expansion sheet 20, the ink 10 of this embodiment in accordance with the designated front face foaming data and the various cyan (C), magenta (M), and yellow (Y) inks in accordance with the designated color image data. As a result, the front side conversion layer 41 and the color ink layer 42 are formed on the ink receiving layer 23, as illustrated in FIG. 10A. Note that, to facilitate comprehension, an example is illustrated in which the front side conversion layer 41 and the color ink layer 42 are formed on the ink receiving layer 23 but, more accurately, the ink 10 and the color ink are received into the ink receiving layer 23 and, as such, the front side photothermal conversion layer 41 and the color ink layer 42 are formed in the ink receiving layer 23. In this case, since the front side conversion layer 41 and the color ink layer 42 are formed simultaneously, the front side conversion layer 41 is depicted using dashed lines in FIG. 10A and the like. Note that a drying step such as step S4 in FIG. 7 may be executed after forming the color ink layer 42 (after step S21).

Second, the user inserts the thermal expansion sheet 20, onto which the front side conversion layer 41 and the color ink layer 42 have been printed, into the expansion unit 53 with the front face facing upward. The expansion unit 53 heats the inserted thermal expansion sheet 20 from the front face (step S22). Specifically, the irradiating unit of the expansion unit 53 irradiates light onto the front face of the thermal expansion sheet 20. The front side conversion layer 41 printed on the front face of the thermal expansion sheet 20 absorbs the irradiated light, thereby generating heat. As a result, as illustrated in FIG. 10B, the region of the thermal expansion sheet 20 where the front side conversion layer 41 was printed bulges and swells.

Third, the user inserts the thermal expansion sheet 20 into the printing unit 52 with the back face facing upward. The printing unit 52 prints the back side photothermal conversion layer (the back side photothermal conversion layer 43) on the back face of the inserted thermal expansion sheet 20 (step S23). The printing unit 52 discharges the ink 10 onto the back face of the thermal expansion sheet 20 in accordance with the designated back face foaming data. As a result, the back side photothermal conversion layer 43 is formed on the back face of the base material 21, as illustrated in FIG. 10C.

Fourth, the user inserts the thermal expansion sheet 20, onto which the back side conversion layer 43 has been printed, into the expansion unit 53 with the back face facing upward. The expansion unit 53 heats the inserted thermal expansion sheet 20 from the back face (step S24). Specifically, the irradiating unit (not illustrated in the drawings) of the expansion unit 53 irradiates light onto the back face of the thermal expansion sheet 20. As a result, as illustrated in FIG. 10D, the region of the thermal expansion sheet 20 where the back side conversion layer 43 was printed bulges and swells.

The pseudo-three-dimensional image is formed in the thermal expansion sheet 20 as a result of carrying out the procedures described above. Since the color of the ink 10 of this embodiment is particularly suppressed, the influence of the ink 10 of the front side conversion layer 41 on the color of the color ink layer 42 can be suppressed. Accordingly, the front side conversion layer 41 and the color ink layer 42 can be formed in a single step, thereby simultaneously forming the front side conversion layer 41 and the color ink layer 42, as depicted in step S21 of this modified example.

This embodiment is not limited to the process order illustrated in FIG. 9, and the back side conversion layer may be formed first. Specifically, in terms of the flowchart illustrated in FIG. 9, step S23 and step S24 are executed, and then steps S21 and S22 are executed.

Additionally, instead of executing the front side swelling step immediately after the front side conversion layer forming step, it is possible to interpose another step such as the color printing step between the front side conversion layer forming step and the front side swelling step. In this case, an order is possible in which steps S1, S3 and S4 of FIG. 7 are executed and then, after all of the steps of printing on the front side of the thermal expansion sheet are completed, the front side swelling step is executed. In this case, step S1 of the flowchart illustrated in FIG. 7 is executed and the front side conversion layer is formed and, then, step S3 and step S4 are executed and the color image is printed. Thereafter, step S2 is executed and the thermal expansion layer is caused to swell. Subsequently, step S5 and step S6 of FIG. 7 are executed and the back side photothermal conversion layer is formed and the thermal expansion layer is caused to swell. In this example, it is also possible to execute the back side conversion layer forming step first. In this case, step S5 and step S6 are executed and, then, steps S1, S3, S4, and S2 are sequentially executed. Here, in step S4, the drying step may be carried out with the front face of the sheet facing upward. It is also possible to perform the color printing step between the back side conversion layer forming step and the back side swelling step. In this case, steps S5, S3, S4, and S6 are sequentially executed, then steps S1 and S2 are executed or, alternatively, steps S1 and S2 are executed, then steps S5, S3, S4, and S6 are sequentially executed. Here, in step S4, the drying step may be carried out with the front face of the sheet facing upward.

The front side conversion layer forming step, the color printing step, and the back side conversion layer forming step can be performed first, and then the front side swelling step and the back side swelling step can be performed. In this case, in terms of the flowchart illustrated in FIG. 7, step S1, step S3, and step S5 are executed first, and then step S2 and step S6 are executed. Note that the order in which step S1, step S3, and step S5 are executed is not limited to this order and these steps may be arranged in any order. For example, an order of step S5, step S3, and step S1 may be used. Moreover, step S2 and step S6 may be executed in this order, or may be executed in the reverse order. Furthermore, the drying step (step S4) may be executed as necessary, or may be omitted.

The front side conversion layer forming step and the back side conversion layer forming step can be performed first, the front side swelling step and the back side swelling step can then be performed, and then the color printing step can be performed. In this case, for, example, in terms of the flowchart illustrated in FIG. 7, step S1 then step S5, or step S5 then step 1 are executed. Next, step S2 then step S6, or step S6 then step S2 are executed and the thermal expansion layer is caused to swell. Thereafter, step S3 and step S4 are executed and the color image is printed. In this case as well, step S4 may be omitted. It is also possible to perform the color printing step between the front side swelling step and the back side swelling step. In this case, step S1 and step S5 are executed, then one of step S2 and step S6 is executed, then step S3 and step S4 are executed, and then the other of step S2 and step S6 is executed. In this case as well, step S4 may be omitted.

Modified Example of Ink 10

Although in the aforementioned embodiments an example is cited of a water-based ink for use in an inkjet printer, this example is not limiting. The ink 10 may be an ultraviolet-curable (UV-curable) ink for use in an inkjet printer. When the ink 10 is an ultraviolet-curable ink, the ink 10 includes an inorganic infrared absorbing agent, and further includes an ultraviolet-curable resin (ultraviolet-curable monomer, ultraviolet-curable oligomer) and a polymerization initiator. Cited examples of the ultraviolet-curable monomer include: isobornyl acrylate, phenoxyethyl acrylate, or the like mono-functional monomers; trimethylolpropane triacrylate, polyethylene glycol diacrylate, or the like poly-functional monomers; or the like. Further, polyester acrylates, polyether acrylates, epoxy acrylates, urethane acrylates, or the like are cited as the ultraviolet-curable oligomer. A urethane acrylate oligomer is preferably used as the ultraviolet-curable oligomer. Either a photo-cleavage type initiator or a hydrogen-abstraction type initiator can be used as the polymerization initiator, and a combination of multiple types of photo-polymerization initiators can be used. Acyl phosphine oxide compounds, acetophenone compounds, or the like are cited as the photo-cleavage type initiator, and benzophenone compounds, thioxanthone compounds, or the like are cited as the hydrogen-abstraction type initiator. In addition to these initiators, any known initiator can be used. Further, the ink 10 may further include solvents and additives.

In addition, the ink 10 may be a non-water-based (oil-based, solvent-based) ink for use in an inkjet printer. In this case, the ink 10 includes, in addition to the inorganic infrared absorbing agent, an organic solvent, resin, or the like. Cited organic solvents are: methyl alcohol, ethyl alcohol, or the like alcohols; acetone, methyl ethyl ketone, or the like ketones; methyl acetate, ethyl acetate, or the like esters; ethylene glycol, diethylene glycol, or the like glycols; and ethylene glycol monomethyl ether, glycol ethers, glycol acetates, saturated hydrocarbons, unsaturated hydrocarbons, or the like. Cited resins are: acrylic type resins, styrene-acrylic type resins, styrene-maleic acid type resins, rosin-based resins, epoxy type resins, silicone type resins, butyral resins, maleic acid resins, phenol resins, urethane resins, melamine resins, or the like. Known additives other than the aforementioned example additives may be used, and such known additives may be included in the ink 10.

If the ink 10 is the ultraviolet-curable type ink or the non-water-based ink, the ink receiving layer 23 may be omitted. Further, the drying step (step S4) illustrated in FIG. 7 may be omitted. If the ink 10 is the ultraviolet-curable type ink or the non-water-based ink, the resin included in the ink 10 preferably has rubber elasticity. In the case of the ultraviolet-curable type ink, urethane acrylates are cited as this type of resin, without particular limitation.

In the description of the aforementioned embodiments, although an example is cited in which the ink is loaded into a cartridge set in an inkjet type printer, this example is not limiting. The ink of the present embodiments can be used in another type of printing (printing apparatus) such as an apparatus for screen printing, gravure printing, offset printing, flexographic printing, or the like. In this case, the ink receiving layer 23 can be omitted. Further, the printing steps illustrated in FIG. 7 (steps S1, S3, and S5) are not necessarily printing by the same printing method, and the aforementioned printing methods can be freely combined. Further, the drying step (step S4) can be omitted.

The ink 10 may be any of the water-based ink, the oil-based ink, and the ultraviolet-curable ink in accordance with the printing method. In this case, the ink 10 includes materials in accordance with the respective printing method, such as, for example, solvents, resins for film formation, auxiliary agents, or the like.

When the ink 10 is the water-based ink, the ink includes the inorganic infrared absorbing agent and also water, an aqueous organic solvent, and a resin. Cited examples of the aqueous organic solvent, without particular limitation, are: polyethylene glycol, polypropylene glycol, or the like polyalkylene glycols; ethylene glycol, triethylene glycol, or the like alkylene glycols; glycerin, glycerols, triethylene glycol monobutyl ether, ethylene glycol methyl(ethyl) ether, diethylene glycol methyl(ethyl) ether, or the like polyalcohol lower-alkyl ethers; and N-methyl-2-pyrolidone, 1,3-dimethyl-2-imidazolidinone, ethanol, or isopropanol. Cited examples of the resin are: acrylic type resins, styrene-acrylic type resins, styrene-maleic acid type reins, rosin type resins, epoxy type resins, silicone type resins, butyral type resins, maleic acid resins, phenol resins urethane resins, melamine resins, or the like. The ink 10 may further include additives. In addition to these cited additives, any known material may be used as an additive.

If the ink 10 is the ultraviolet-curable ink, the ink 10 includes the inorganic infrared absorbing agent and further includes an ultraviolet-curable resin (ultraviolet-curable monomer, ultraviolet-curable oligomer) and a polymerization initiator. Cited ultraviolet-curable monomers are: isobornyl acrylate, phenoxyethyl acrylate, or the like mono-functional monomers; trimethylolpropane triacetate, propylene glycol diacrylate, or the like poly-functional monomers; or the like. Cited ultraviolet-curable oligomers are: polyester acrylates, polyether acrylates, epoxy acrylates, urethane acrylates, or the like. Urethane acrylate oligomers are preferably used. A photo-cleavage type initiator or a hydrogen-abstraction type initiator can be used as the polymerization initiator, and a combination of multiple types of photo-polymerization initiator can be used. Acyl phosphine oxide compounds, acetophenone compounds, or the like are cited as the photo-cleavage type initiator; and benzophenone compounds, thioxanthone compounds, or the like are cited as the hydrogen-abstraction type initiator. In addition to these initiators, any known initiator can be used. Further, the ink 10 may further include solvents and additives.

The ink 10 may be a non-water-based (oil-based, solvent-based) ink. In this case, the ink 10 includes, in addition to the inorganic infrared absorbing agent, an organic solvent, resin, or the like. Cited organic solvents are: methyl alcohol, ethyl alcohol, or the like alcohols; acetone, methyl ethyl ketone, or the like ketones; methyl acetate, ethyl acetate, or the like esters; ethylene glycol, diethylene glycol, or the like glycols; and ethylene glycol monomethyl ether, glycol ethers, glycol acetates, saturated hydrocarbons, unsaturated hydrocarbons, or the like. Cited resins are: acrylic type resins, styrene-acrylic type resins, styrene-maleic acid type resins, rosin-based resins, epoxy type resins, silicone type resins, butyral resins, maleic acid resins, phenol resins, urethane resins, melamine resins, or the like. Known additives other than the aforementioned example additives may be used, and such additives may be included in the ink 10.

Also in the case in which the ink 10 is used in the offset printing apparatus or the like, the resin included in the ink 10 preferably has rubber elasticity. In the case of the ultraviolet-curable type ink, urethane acrylates are cited as this type of resin, without particular limitation.

In addition, for example, in the case in which the offset printing apparatus is used, as illustrated in FIG. 9 and FIG. 10, the color printing step and the front side conversion layer forming step are combined, and the color ink layer and the front side conversion layer are printed in a single step, the offset printing apparatus is equipped with inks for printing the color image such as CMYK and the ink 10 of the present embodiment, and the color ink layer and the front side conversion layer are printed in order using these inks. In this case, the order of the sequence of printing using the ink 10 can be changed as desired. In other words, the printing using the ink 10 can be before or after the printing using the CMYK color ink, or may be between the printings using the CMYK color ink. Printing in this manner similarly may be performed for printing apparatuses other than the offset printing apparatus.

Comparative Example

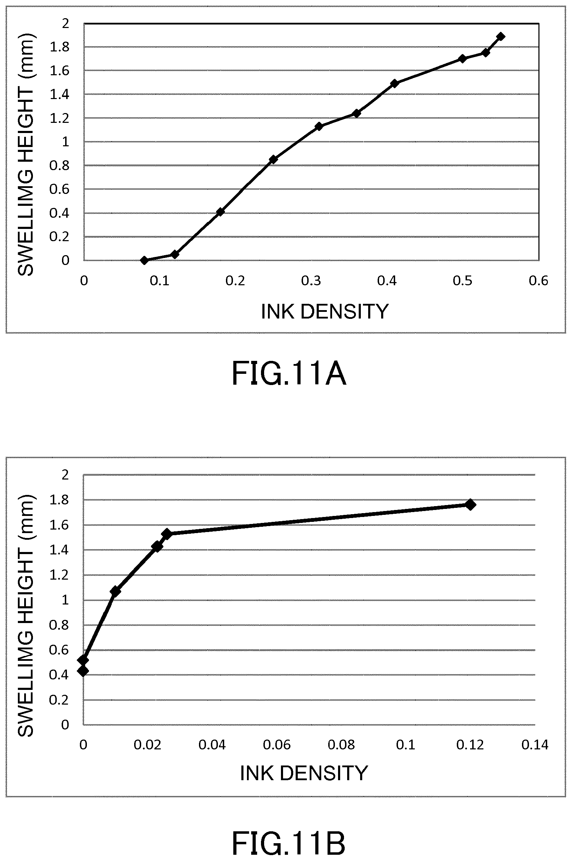

A comparative example is illustrated in FIG. 11A in which a carbon-containing black ink (pigment ink), traditionally used to form photothermal conversion layers, was used to form a photothermal conversion layer, and the photothermal conversion layer is caused to foam and swell. FIG. 11A is a graph illustrating the relationship between ink density (black density) of the photothermal conversion layer after printing and the swelling height (foaming height) of the thermal expansion layer after swelling. Specifically, a commercially available carbon-containing black pigment ink typically used in inkjet printers was used as the black ink. A plurality of photothermal conversion layers were formed by printing the same image, using an inkjet printer and the black ink, at a plurality of different densities on the front face of a thermal expansion sheet having the same configuration as described above in the embodiment. In this case, the photothermal conversion layers were only formed on the front face of the thermal expansion sheet. Using a halogen lamp, each of the photothermal conversion layers was irradiated with light under the same conditions, and the swelling height (mm) of the thermal expansion sheet at each density was measured. The black density was measured using an eXact reflection spectral densitometer (manufactured by Sakata INX ENG. Co., Ltd.).

Example 1

An example is illustrated in FIG. 11B in which an ink corresponding to the ink 10 of this embodiment was used to form a photothermal conversion layer, and the photothermal conversion layer was caused to foam and swell. FIG. 11B is a graph illustrating the relationship between ink density (black density) of the photothermal conversion layer after printing and the swelling height (foaming height) of the thermal expansion layer after swelling. The ink corresponding to the ink 10 of this embodiment that was used included ingredients similar to those of typical ink. Specifically, the ink 10 was obtained by mixing 5.3 wt.% of cesium tungsten oxide as the inorganic infrared absorbing agent in an ink (water-based) free of coloring agents. As in the Comparative Example, a plurality of photothermal conversion layers were formed by printing the same image at different densities. In this case, the photothermal conversion layers were only formed on the front face of the thermal expansion sheet. Additionally, as in the Comparative Example, each of the photothermal conversion layers was irradiated with light under the same conditions, and the swelling height (mm) of the thermal expansion sheet at each density was measured. The black density was measured using the same reflection spectral densitometer used in the Comparative Example.

As illustrated in FIG. 11B, the thermal expansion layer could be made to swell even when using the ink of the Example 1. Moreover, as with the Comparative Example illustrated in FIG. 11A in which the conventional black ink was used, the swelling height increased in accordance with the density. In the Comparative Example illustrated in FIG. 1 1A, hardly any swelling height was obtained when the black density of the photothermal conversion layer was less than 0.1. In contrast, with the photothermal conversion layer in which the ink of the Example 1 was used, swelling height of about 1.5 mm was obtained even when the black density was less than 0.1. Moreover, in the Comparative Example, the black density at which a swelling height of about 1.5 mm can be obtained was about 0.4. Accordingly, by using the ink of the Example 1, identical swelling height can be obtained while suppressing the color of the photothermal conversion layer.

Visual confirmation of the color of photothermal conversion was possible at black densities of about 0.02 or greater. Therefore, visual recognition of the color of the photothermal conversion layer (the ink) was not possible when the black density was set to 0.01. Accordingly, with the ink of the Example, swelling height, equivalent to that achieved by conventional black inks with a black density of 0.4 to 0.5, was obtained near the density at the limit of visual recognition. Furthermore, foaming and swelling of the thermal expansion layer could be caused even at black densities that are visually unrecognizable. Note that, while the swelling height decreased slightly at black densities of less than 0.01, the photothermal conversion layer can be made to foam higher than the values illustrated in FIG. 11B by lengthening the amount of time that the photothermal conversion layers are irradiated with the light. Additionally, even in regions where the density exceeded 0.02, a photothermal conversion layer with color suppressed more than in conventional black inks could be formed.

Example 2

In order to show that the ink in a transparent state (base of the ink 10) free of the inorganic infrared absorbing agent does not mask the color of the sheet forming the base sheet, an ultraviolet-curable type clear inkjet printer-type ink free of the coloring agent or the like was used, and printing was performed on a black sheet. Applications were performed multiple times at the same density. Further, the multiple applications were performed so as to overlap the locations of prior applications. The Lab values and black densities of the ink layer in this case are listed in Table 1. The Lab values and density values were measured using an eXact reflection spectral densitometer (manufactured by Sakata INX ENG. Co., Ltd.). The Lab values and black densities indicated for an applications count of zero correspond to the color of the sheet. As listed in Table 1, although values changed due to printing of the ink on the sheet surface, there was little difference of the black density between the 0th and the 2nd-6th applications, and the Lab values among the 2nd-6th applications were almost the same. Thus the color of the sheet forming the base sheet was not masked by the clear type ink. In the present embodiment, the base of the ink 10 was transparent like the clear ink according to Example 2, the color of the sheet forming the base sheet was visually recognizable after printing, and the color was not masked by the ink layer.

Table 1

| | Number of Applications | | | |
|---|---|---|---|---|
| | 0 | 2 | 4 | 6 |
| L | 20.09 | 11.74 | 12.01 | 11.77 |
| a | 0.39 | 0.6 | 0.54 | 0.52 |
| b | 1.29 | 2.76 | 2.78 | 2.98 |
| Black Density | 2 | 2.06 | 2.05 | 2.06 |

For comparison, an ink layer was formed by an inkjet printer on a black sheet using an ultraviolet-curable type inkjet printer white ink, and results of measurement of the ink layer Lab values and black densities are listed in Table 2. Applications were performed multiple times at the same density. Further, the multiple applications were performed so as to overlap the locations of prior applications. The Lab values and density values were measured using an eXact reflection spectral densitometer (manufactured by Sakata INX ENG. Co., Ltd.). The Lab values and black densities indicated for an applications count of zero correspond to the color of the sheet. As listed in Table 2, the black density decreased to 0.04 by printing twice using white ink, and the black density at the 4th application reached 0. In this manner, the color of the base sheet was masked with each count of the overlapped printing, and the color of the sheet forming the base sheet became visually unrecognizable.

Table 2

| | Number of Applications | | | |
|---|---|---|---|---|
| | 0 | 2 | 4 | 6 |
| L | 20.04 | 92.68 | 95.35 | 96.52 |
| a | 0.33 | -3.2 | -2.32 | -1.92 |
| b | 1.16 | -2.1 | 0.47 | 2.12 |
| Black Density | 2.04 | 0.04 | 0 | 0 |

Example 3

Next, in Example 3, an ink according to Example 3 was prepared by mixing cesium tungsten oxide in a medium (not including white pigment) including urethane acrylate as a UV-curable resin. Concentration of the cesium tungsten oxide in the ink was 10% by weight. A photothermal conversion layer was printed on a thermal expansion sheet (500 $\mu$m thick) by an offset printer using this ink. Density of printed photothermal conversion layer was set in 10% increments over a range of 0% to 100%. Further, the ink was printed as 3 or 4 overlapping applications. Prior to causing expansion of the thermal expansion layer, the respective color (Lab values) and black density were measured for the photothermal conversion layer using an eXact reflection spectral densitometer (manufactured by Sakata INX ENG. Co., Ltd.). Further,

14

a halogen lamp (1,000 W, 2,500K) was moved at a speed of 20 mm/s over the thermal expansion sheet, the photothermal conversion layer was irradiated by electromagnetic radiation, and the thermal expansion layer was expanded. Thereafter, the color (Lab values) and black density of the photothermal conversion layer after thermal expansion layer expansion were measured using an eXact reflection spectral densitometer (manufactured by Sakata INX ENG. Co., Ltd.).

The Lab values of the photothermal conversion layer formed by printing three times prior to expansion of the thermal expansion layer are listed in Table 3. Further, ΔE listed in Table 3 was calculated using the aforementioned Equation 1 from the Lab values of the region of 0% density. Since the ink is not present in the 0% density region, the Lab values of the 0% density region correspond to the Lab values of the surface of the thermal expansion sheet. Further, black density, and the Hunter whiteness calculated from the Lab values using the below indicated Equation 2, are listed in Table 3.

$$\text{Hunter whiteness} = 100 - [(100 - L)^2 + a^2 + b^2]^{1/2} \quad \ldots \quad \text{(Equation 2)}$$

Table 3

| % | L | a | b | ΔE | Blackness | Whiteness |
|---|---|---|---|---|---|---|
| 100 | 92.18 | -3.29 | 2.11 | 3.8 | 0.05 | 9.126 |
| 90 | 92.99 | -3.2 | 2.18 | 3.2 | 0.04 | 91.99 |
| 80 | 93.74 | -2.37 | 2.13 | 2.1 | 0.03 | 92.98 |
| 70 | 93.3 | -1.18 | 2.16 | 2.0 | 0.03 | 92.73 |
| 60 | 93.5 | -1.61 | 2.19 | 1.8 | 0.04 | 92.95 |
| 50 | 93.63 | -1.27 | 2.17 | 1.5 | 0.02 | 93.15 |
| 40 | 94.22 | -10.2 | 1.92 | 0.8 | 0.01 | 93.82 |
| 30 | 94.39 | -0.84 | 1.73 | 0.5 | 0.01 | 94.07 |
| 20 | 94.48 | -0.75 | 1.63 | 0.4 | 0 | 94.20 |
| 10 | 94.66 | -0.67 | 1.57 | 0.2 | 0 | 94.39 |
| 0 | 94.76 | -0.6 | 1.46 | 0.0 | 0 | 94.53 |

Next, Lab values of the photothermal conversion layer formed by printing three times and then expanding the thermal expansion layer are illustrated in Table 4. Further, ΔE listed in Table 4 was also calculated using the aforementioned Equation 1 from the Lab values of the region of 0% density. Further, black density, and the Hunter whiteness calculated from the Lab values using the above indicated Equation 2, are listed in Table 4.

Table 4

| % | L | a | b | ΔE | Blackness | Whiteness |
|---|---|---|---|---|---|---|
| 100 | 91.97 | -3.69 | 2.24 | 4.3 | 0.06 | 90.88 |
| 90 | 92.96 | -3.11 | 2.33 | 3.2 | 0.04 | 91.96 |
| 80 | 93.41 | -1.6 | 2.41 | 1.9 | 0.03 | 92.80 |
| 70 | 93.91 | -2.29 | 2.29 | 2.0 | 0.03 | 93.10 |
| 60 | 93.58 | -1.77 | 2.32 | 1.8 | 0.03 | 92.95 |
| 50 | 93.73 | -1.28 | 2.24 | 1.4 | 0.02 | 93.22 |
| 40 | 94.28 | -0.98 | 2.01 | 0.8 | 0.01 | 93.86 |
| 30 | 94.48 | -0.83 | 1.84 | 0.5 | 0.01 | 94.12 |
| 20 | 94.53 | -0.73 | 1.72 | 0.3 | 0 | 94.22 |
| 10 | 94.71 | -0.64 | 1.67 | 0.1 | 0 | 94.42 |

(continued)

| % | L | a | b | ΔE | Blackness | Whiteness |
|---|---|---|---|---|---|---|
| 0 | 94.81 | -0.58 | 1.63 | 0.0 | 0 | 94.53 |

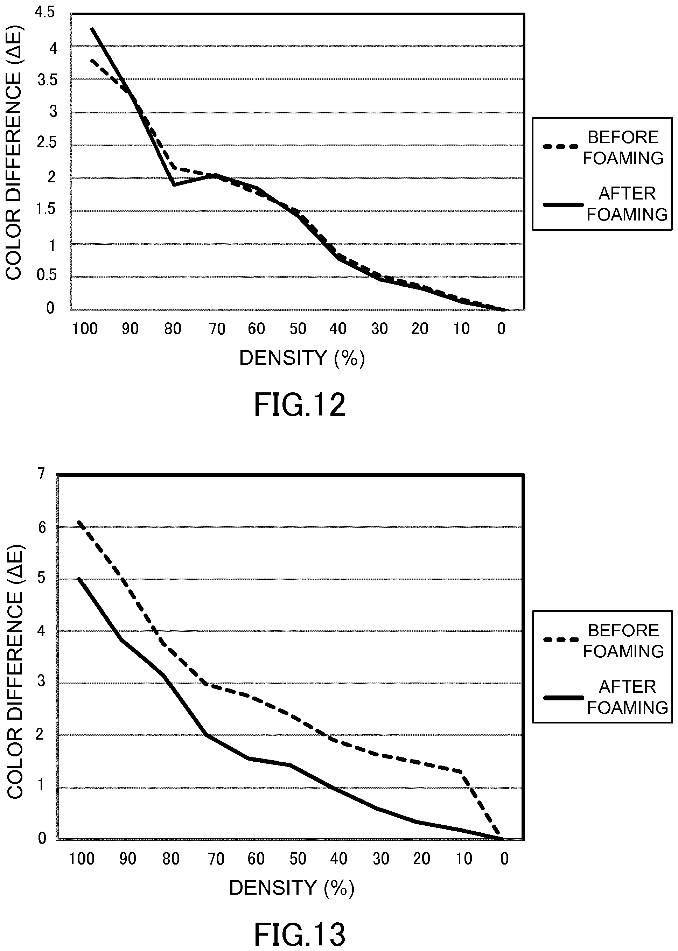

Further, FIG. 12 is a graph illustrating the ΔE values listed in Table 3 and Table 4. In FIG. 12, the ΔE value is illustrated at each printing density before and after expansion of the thermal expansion layer. Good foaming was seen in the range of 30% to 100% density. Further, ΔE of the 30% to 100% densities in which foaming was seen were the 0.5 to 3.8 values as listed in Table 3 prior to foaming, and were the 0.5 to 4.3 values as listed in Table 4 after foaming. Thus in the density range of 30% to 90%, a photothermal conversion layer could be formed for which ΔE was less than or equal to 3.2, and further, expansion of the thermal expansion layer could be caused using the photothermal conversion layer having ΔE less than or equal to 3.2. Further, the black density in this range was less than or equal to 0.04 and was either nearly unrecognizable, or had color that was slightly recognizable. From the Hunter whiteness, whiteness is understood have been high. Further, by changing the irradiation conditions in a working example by slowing the speed of movement of the halogen lamp, by slowing the transport speed of the sheet, or the like, the thermal expansion layer can be made to foam even using a photothermal conversion layer having a density lower than 30%.

Next, Lab values, occurring prior to expansion of the thermal expansion layer, of a photothermal conversion layer formed by printing four times are listed in Table 5. Further, ΔE listed in Table 5 was also calculated using the aforementioned Equation 1 from the Lab values of the region of 0% density. Further, black density, and the Hunter whiteness calculated from the Lab values using the above indicated Equation 2, are listed in Table 5.

Table 5

| % | L | a | b | ΔE | Blackness | Whiteness |
|---|---|---|---|---|---|---|
| 100 | 91 | -4.05 | 2.63 | 6.1 | 0.08 | 89.79 |
| 90 | 92.36 | -3.66 | 2.68 | 5.0 | **0.06** | 91.11 |
| 80 | 93.26 | -2.75 | 2.49 | 3.8 | 0.04 | 92.39 |
| 70 | 94.1 | -2.15 | 2.45 | 3.0 | 0.02 | 93.26 |
| 60 | 93.76 | -1.85 | 2.28 | 2.8 | 0.02 | 93.10 |
| 50 | 93.87 | -1.46 | 2.32 | 2.4 | 0.02 | 93.29 |
| 40 | 94.23 | -1.14 | 2.06 | 1.9 | 0.01 | 93.77 |
| 30 | 94.38 | -0.95 | 1.88 | 1.6 | 0.01 | 94.00 |
| 20 | 94.43 | -0.83 | 1.74 | 1.5 | 0.01 | 94.11 |
| 10 | 94.65 | -0.7 | 1.64 | 1.3 | 0 | 94.36 |
| 0 | 94.78 | 0.6 | 1.51 | 0.0 | 0 | 94.53 |

Lab values of a photothermal conversion layer formed by printing four times and then expanding the thermal expansion layer are listed in Table 6. Further, ΔE listed in Table 6 was also calculated using the aforementioned Equation 1 from the Lab values of the region of 0% density. Further, black density, and the Hunter whiteness calculated from the Lab values using the above indicated Equation 2, are listed in Table 6.

Table 6

| % | L | a | b | ΔE | Blackness | Whiteness |
|---|---|---|---|---|---|---|
| 100 | 91.19 | -3.98 | 2.76 | 5.0 | 0.07 | 89.95 |
| 90 | 92.41 | -3.39 | 2.86 | 3.8 | 0.06 | 91.21 |
| 80 | 92.5 | -2.57 | 2.73 | 3.2 | 0.05 | 91.62 |
| 70 | 93.96 | -2.1 | 2.69 | 2.0 | 0.03 | 93.06 |
| 60 | 94.17 | -1.77 | 2.47 | 1.6 | 0.02 | 93.43 |
| 50 | 93.96 | -1.41 | 2.54 | 1.4 | 0.02 | 93.30 |

(continued)

| % | L | a | b | ∆E | Blackness | Whiteness |
|---|---|---|---|---|---|---|
| 40 | 94.17 | -1.11 | 2.3 | 1.0 | 0.01 | 93.64 |
| 30 | 94.44 | -0.92 | 2.06 | 0.6 | 0.01 | 94.00 |
| 20 | 94.54 | -0.78 | 1.85 | 0.3 | 0 | 94.18 |
| 10 | 94.76 | -0.64 | 1.77 | 0.2 | 0 | 94.43 |
| 0 | 94.67 | -0.55 | 1.64 | 0.0 | 0 | 94.40 |

Further, FIG. 13 is a graph illustrating the ∆E values listed in Table 5 and Table 6. In FIG. 13, the ∆E value is illustrated at each printing density before and after expansion of the thermal expansion layer. Good foaming was seen in the range of 20% to 100% density. Further, ∆E of the 20% to 100% densities in which foaming was seen were the 1.5 to 6.1 values as listed in Table 5 prior to foaming, and were the 0.3 to 5.0 values as listed in Table 6 after foaming. In the examples illustrated in FIG. 13, whatever the density, ∆E after foaming was low in comparison to ∆E prior to foaming. Particularly at 80% density, although ∆E prior to foaming was above 3.2, ∆E after foaming was 3.2. Thus the density of 80% is also included in the colorless transparent photothermal conversion layer of the present embodiment. Thus in the density range of 20% to 80%, a photothermal conversion layer could be formed for which ∆E was less than or equal to 3.2, and further, expansion of the thermal expansion layer could be caused using the photothermal conversion layer having ∆E less than or equal to 3.2. Further, the black density was less than or equal to 0.03 and was either nearly unrecognizable, or had color that was slightly recognizable. From the Hunter whiteness, whiteness is understood have been high. Further, by changing the irradiation conditions by slowing the speed of movement of the halogen lamp, by slowing the transport speed of the sheet, or the like, the thermal expansion layer can be made to foam even using a photothermal conversion layer having a density lower than 20%.

Thus the ink 10 of the present embodiment can suppress color and can form a colorless transparent photothermal conversion layer.

The present disclosure is not limited to the aforementioned embodiments, and various types of modifications and applications are possible.

The colorless transparent photothermal conversion layer of the present embodiment can also be formed on the back face of the thermal expansion sheet. In this case, the color difference between the photothermal conversion layer and the thermal expansion sheet is calculated, in the same manner as in FIG. 1, between the photothermal conversion layer and the back face thermal expansion sheet. In this case, the color difference is extremely small, and ∆E is preferably less than or equal to 3.2. Further, in the cases such as when the back face of the thermal expansion sheet is difficult to visually recognize, and when having of a color by the back face photothermal conversion layer is not a problem, ∆E of the back face photothermal conversion layer may be larger than 3.2. Further, the colorless transparent photothermal conversion layer of the present embodiment is formed on the front face and/or back face of the thermal expansion sheet.

In the present embodiment, a pseudo-three-dimensional image forming system 50 example is cited, as a printing apparatus that is equipped with a control unit 51, an expansion unit 53, or the like, although this example is not limiting, and the printing apparatus may be configured to consist of an inkjet type printing unit 52 such as that illustrated in FIG. 6.

Further, although the aforementioned embodiment cites an example of a configuration that prints the photothermal conversion layer by heating a specific region of the thermal expansion sheet, as long as ink is used for heating a specific region, use is possible for articles other than the thermal expansion sheet.

Although the aforementioned embodiment cites an example of a configuration that forms the photothermal conversion layer on the front face and the back face of the thermal expansion sheet, this configuration is not limiting. In all aspects of the present disclosure, the photothermal conversion layer can be formed on the front face alone or on the back face alone.

Further, in the drawings, each of the layers of the thermal expansion sheet, the photothermal conversion layers (front face and back face), and the color ink layers are all exaggerated as required for description. Thus the illustrations of shapes, thicknesses, colors, or the like of such layers are not intended to be limiting.

## Claims

1. A manufacturing method for manufacturing a shaped object by using a photothermal conversion layer (41, 43) for causing expansion of at least a portion of a thermal expansion layer (22) of a thermal expansion sheet (20), the manufacturing method comprising:

forming the photothermal conversion layer (41, 43) using an ink (10) on at least one surface of the thermal expansion sheet (20), the ink (10) comprising (i) an inorganic infrared absorbing agent having a higher absorptivity in at least one region of an infrared light spectrum than in a visible light spectrum, and (ii) a base that is transparent to visible light, and
irradiating a front and/or back face of the thermal expansion sheet (20) with light to cause expansion of at least the portion of the thermal expansion layer (22), **characterized in that** the photothermal conversion layer (41, 43) is transparent to visible light.

2. The manufacturing method according to claim 1, wherein a color difference ΔE*ab is less than or equal to 3.2, is calculated using L*a*b* color coordinates, and occurs between (i) the photothermal conversion layer (41, 43) formed using the ink (10) on at least one surface of the thermal expansion sheet (20), and (ii) the at least one surface of the thermal expansion sheet (20).

3. The manufacturing method according to claim 1 or 2, wherein the inorganic infrared absorbing agent comprises at least one of cesium tungsten oxide or lanthanum hexaboride.

4. The manufacturing method according to any one of claims 1 to 3, further comprising:

printing a color image (42) on one surface of the thermal expansion sheet (20),
wherein the forming of the photothermal conversion layer (41) on the one surface and the printing of the color image (42) are simultaneous (S21).

5. The manufacturing method according to any one of claims 1 to 3, further comprising:

printing (S3) a color image (42) on one surface of the thermal expansion sheet (20),
wherein the printing (S3) of the color image (42) is performed before the forming (S1) of the photothermal conversion layer (41) on the one surface.

6. A thermal expansion sheet (20) comprising:

a thermal expansion layer (22) that swells due to heat; and
a photothermal conversion layer (41, 43) for causing expansion of the thermal expansion layer (22), wherein the photothermal conversion layer (41, 43) comprises an inorganic infrared absorbing agent having a higher absorptivity in at least one region of an infrared light spectrum than in a visible light spectrum, **characterized in that**
the photothermal conversion layer (41, 43) is transparent to visible light.

7. The thermal expansion sheet (20) according to claim 6, **characterized in that** a color difference ΔE*ab is less than or equal to 3.2, is calculated using L*a*b* color coordinates, and occurs between (i) the photothermal conversion layer (41, 43) formed on at least one surface of the thermal expansion sheet (20) and (ii) the at least one surface of the thermal expansion sheet (20).

8. The thermal expansion sheet (20) according to claim 6 or 7, **characterized in that** the inorganic infrared absorbing agent comprises at least one of cesium tungsten oxide or lanthanum hexaboride.

9. A printing method for printing a photothermal conversion layer (41, 43) used for causing expansion of at least a portion of a thermal expansion layer (22) of a thermal expansion sheet (20), the printing method comprising:

printing the photothermal conversion layer (41, 43) using an ink (10) on at least one surface of the thermal expansion sheet (20), the ink (10) comprising (i) an inorganic infrared absorbing agent having a higher absorptivity in at least one region of an infrared light spectrum than in a visible light spectrum, and (ii) a base that is transparent to visible light,
**characterized in that** the photothermal conversion layer (41, 43) is transparent to visible light.

10. The printing method according to claim 9, wherein the printing method is inkjet printing, screen printing, gravure printing, offset printing, orflexographic printing.

**11.** A system configured to manufacture a shaped object by using a photothermal conversion layer (41, 43) for causing, using an expansion unit (53), expansion of at least a portion of a thermal expansion layer (22) of a thermal expansion sheet (20), the system comprising:

a printing unit (52) configured to form the photothermal conversion layer (41, 43) using an ink (10) on at least one surface of the thermal expansion sheet (20), the ink (10) comprising (i) an inorganic infrared absorbing agent having a higher absorptivity in at least one region of an infrared light spectrum than in a visible light spectrum, and (ii) a base that is transparent to visible light, and

an irradiating unit configured to irradiate a front and/or back face of the thermal expansion sheet (20) with light to cause expansion of at least the portion of the thermal expansion layer (22), **characterized in that** the photothermal conversion layer (41, 43) is transparent to visible light.

**Patentansprüche**

**1.** Herstellungsverfahren zum Herstellen eines geformten Gegenstandes unter Verwendung einer photothermischen Wandlungsschicht (41, 43), mit der Ausdehnung wenigstens eines Abschnitts einer Wärmedehnungsschicht (22) eines Wärmedehnungsbogens (20) bewirkt wird, wobei das Herstellungsverfahren umfasst:

Ausbilden der photothermischen Wandlungsschicht (41, 43) unter Verwendung einer Tinte (10) auf wenigstens einer Oberfläche des Wärmedehnungsbogens (20), wobei die Tinte (10) (i) ein anorganisches infrarotabsorbierendes Mittel mit einem Absorptionsvermögen, das in wenigstens einem Bereich eines Infrarotlicht-Spektrums höher ist als in einem Spektrum von sichtbarem Licht, sowie (ii) einen Träger umfasst, der für sichtbares Licht transparent ist, und

Bestrahlen einer Vorder- und/oder Rückseite des Wärmedehnungsbogens (20) mit Licht, um Ausdehnung wenigstens eines Abschnitts der Wärmedehnungsschicht (22) zu bewirken, **dadurch gekennzeichnet, dass** die photothermische Wandlungsschicht (41, 43) für sichtbares Licht transparent ist.

**2.** Herstellungsverfahren nach Anspruch 1, wobei ein Farbunterschied ΔE*ab 3,2 oder weniger beträgt, unter Verwendung von L*a*b*-Farbkoordinaten berechnet wird und zwischen (i) der photothermischen Wandlungsschicht (41, 43), die unter Verwendung der Tinte (10) auf wenigstens einer Oberfläche des Wärmedehnungsbogens (20) ausgebildet wird, und (ii) der wenigstens einen Oberfläche des Wärmedehnungsbogens (20) auftritt.

**3.** Herstellungsverfahren nach Anspruch 1 oder 2, wobei das anorganische infrarotabsorbierende Mittel Cäsium-Wolframoxid oder/und Lanthanhexaborid umfasst.

**4.** Herstellungsverfahren nach einem der Ansprüche 1 bis 3, das des Weiteren umfasst:

Aufdrucken eines Farbbildes (42) auf eine Oberfläche des Wärmedehnungsbogens (20),
wobei das Ausbilden der photothermischen Wandlungsschicht (41) auf der einen Oberfläche und das Aufdrucken des Farbbildes (42) gleichzeitig erfolgen (S21).

**5.** Herstellungsverfahren nach einem der Ansprüche 1 bis 3, das des Weiteren umfasst:

Aufdrucken (S3) eines Farbbildes (42) auf eine Oberfläche des Wärmedehnungsbogens (20),
wobei das Aufdrucken (S3) des Farbbildes (42) vor dem Ausbilden (S1) der photothermischen Wandlungsschicht (41) auf der einen Oberfläche durchgeführt wird.

**6.** Wärmedehnungsbogen (20), der umfasst:

eine Wärmedehnungsschicht (22), die durch Wärme aufquillt; und
eine photothermische Wandlungsschicht (41, 43), die Ausdehnung der Wärmedehnungsschicht (22) bewirkt, wobei
die photothermische Wandlungsschicht (41, 43) ein anorganisches infrarotabsorbierendes Mittel mit einem Absorptionsvermögen umfasst, das in wenigstens einem Bereich eines Infrarotlicht-Spektrums höher ist als in einem Spektrum von sichtbarem Licht, **dadurch gekennzeichnet, dass**
die photothermische Wandlungsschicht (41, 43) für sichtbares Licht transparent ist.

**7.** Wärmedehnungsbogen (20) nach Anspruch 6, **dadurch gekennzeichnet, dass** ein Farbunterschied ∆E*ab 3,2 oder weniger beträgt, unter Verwendung von L*a*b*-Farbkoordinaten berechnet wird und zwischen (i) der photothermischen Wandlungsschicht (41, 43), die auf wenigstens einer Oberfläche des Wärmedehnungsbogens (20) ausgebildet ist, und (ii) der wenigstens einen Oberfläche des Wärmedehnungsbogens (20) auftritt.

**8.** Wärmedehnungsbogen (20) nach Anspruch 6 oder 7, **dadurch gekennzeichnet, dass** das anorganische infrarotabsorbierende Mittel Cäsium-Wolframoxid oder/und Lanthanhexaborid umfasst.

**9.** Druckverfahren zum Bedrucken einer photothermischen Wandlungsschicht (41, 43), mit der Ausdehnung wenigstens eines Abschnitts einer Wärmedehnungsschicht (22) eines Wärmedehnungsbogens (20) bewirkt wird, wobei das Druckverfahren umfasst:

Aufdrucken der photothermischen Wandlungsschicht (41, 43) unter Verwendung einer Tinte (10) auf wenigstens eine Oberfläche des Wärmedehnungsbogens (20), wobei die Tinte (10) (i) ein anorganisches infrarotabsorbierendes Mittel mit einem Absorptionsvermögen, das in wenigstens einem Bereich eines Infrarotlicht-Spektrums höher ist als in einem Spektrum von sichtbarem Licht, sowie (ii) einen Träger umfasst, der für sichtbares Licht transparent ist,
**dadurch gekennzeichnet, dass** die photothermische Wandlungsschicht (41, 43) für sichtbares Licht transparent ist.

**10.** Druckverfahren nach Anspruch 9, wobei das Druckverfahren Tintenstrahldruck, Siebdruck, Tiefdruck, Offsetdruck oder Flexodruck ist.

**11.** System, das zum Herstellen eines geformten Gegenstandes unter Verwendung einer photothermischen Wandlungsschicht (41, 43) ausgeführt ist, mit der unter Verwendung einer Ausdehnungs-Einheit (53) Ausdehnung wenigstens eines Abschnitts einer Wärmedehnungsschicht (22) eines Wärmedehnungsbogens (20) bewirkt wird, wobei das System umfasst:

eine Druck-Einheit (52), die zum Ausbilden der photothermischen Wandlungsschicht (41, 43) unter Verwendung einer Tinte (10) auf wenigstens einer Oberfläche des Wärmedehnungsbogens (20) ausgeführt ist, wobei die Tinte (10) (i) ein anorganisches infrarotabsorbierendes Mittel mit einem Absorptionsvermögen, das in wenigstens einem Bereich eines Infrarotlicht-Spektrums höher ist als in einem Spektrum von sichtbarem Licht, sowie (ii) einen Träger umfasst, der für sichtbares Licht transparent ist, und
eine Bestrahlungs-Einheit, die so ausgeführt ist, dass sie eine Vorder- und/oder eine Rückseite des Wärmedehnungsbogens (20) mit Licht bestrahlt, um Ausdehnung wenigstens des Abschnitts der Wärmedehnungsschicht (22) zu bewirken,
**dadurch gekennzeichnet, dass** die photothermische Wandlungsschicht (41, 43) für sichtbares Licht transparent ist.

## Revendications

**1.** Procédé de fabrication destiné à la réalisation d'un objet façonné en utilisant une couche de conversion photo-thermique (41, 43) permettant de provoquer la dilatation d'au moins une portion d'une couche de dilatation thermique (22) d'une feuille de dilatation thermique (20), le procédé de fabrication comprenant :

la formation de la couche de conversion photo-thermique (41, 43) en utilisant une encre (10) sur au moins une surface de la feuille de dilatation thermique (20), l'encre (10) comprenant (i) un agent d'absorption infrarouge inorganique présentant un coefficient d'absorption dans au moins une zone d'un spectre de lumière infrarouge plus grand que dans le spectre de lumière visible, et (ii) une base qui est transparente à la lumière visible, et l'illumination de la face avant et/ou arrière de la feuille de dilatation thermique (20) dans le but de provoquer la dilatation d'au moins la portion de la couche de dilatation thermique (22),
**caractérisé en ce que** la couche de conversion photo-thermique (41, 43) est transparente à la lumière visible.

**2.** Procédé de fabrication selon la revendication 1, dans lequel la différence de couleurs ∆E*ab, qui est inférieure ou égale à 3,2, est calculée en utilisant les coordonnées de couleurs L*a*b, et apparaît entre (i) la couche de conversion photo-thermique (41, 43) formée en utilisant l'encre (10) sur au moins une surface de la feuille de dilatation thermique (20), et (ii) la ou les surfaces de la feuille de dilatation thermique (20).

3. Procédé de fabrication selon la revendication 1 ou la revendication 2, dans lequel l'agent d'absorption infrarouge inorganique comprend au moins l'un parmi l'oxyde de césium tungstène ou l'hexaborure de lanthane.

4. Procédé de fabrication selon l'une quelconque des revendications 1 à 3, comprenant en outre :

   l'impression d'une image en couleurs (42) sur une première surface de la feuille de dilatation thermique (20), où la formation de la couche de conversion photo-thermique (41) sur la première surface et l'impression de l'image en couleurs (42) sont simultanées (S21).

5. Procédé de fabrication selon l'une quelconque des revendications 1 à 3, comprenant en outre :

   l'impression (S3) d'une image en couleurs (42) sur une première surface de la feuille de dilatation thermique (20), où l'impression (S3) de l'image en couleurs (42) est effectuée avant la formation (S1) de la couche de conversion photo-thermique (41) sur la première surface.

6. Feuille de dilatation thermique (20) comprenant :

   une couche de dilatation thermique (22) qui s'enfle en raison de la chaleur, et
   une couche de conversion photo-thermique (41, 43) destinée à provoquer la dilatation de la couche de dilatation thermique (22), où
   la couche de conversion photo-thermique (41, 43) comprend un agent d'absorption infrarouge inorganique présentant un coefficient d'absorption dans au moins une zone d'un spectre de lumière infrarouge plus grand que dans le spectre de lumière visible,
   **caractérisée en ce que** la couche de conversion photo-thermique (41, 43) est transparente à la lumière visible.

7. Feuille de dilatation thermique (20) selon la revendication 6, **caractérisée en ce que** la différence de couleurs ΔE*ab, qui est inférieure ou égale à 3,2, est calculée en utilisant les coordonnées de couleurs L*a*b, et apparaît entre (i) la couche de conversion photo-thermique (41, 43) formée en utilisant l'encre (10) sur au moins une surface de la feuille de dilatation thermique (20), et (ii) la ou les surfaces de la feuille de dilatation thermique (20) .

8. Feuille de dilatation thermique (20) selon la revendication 6 ou la revendication 7, **caractérisée en ce que** l'agent d'absorption infrarouge inorganique comprend au moins l'un parmi l'oxyde de césium tungstène ou l'hexaborure de lanthane.

9. Procédé d'impression permettant l'impression d'une couche de conversion photo-thermique (41, 43) utilisé pour provoquer la dilatation d'au moins une portion d'une couche de dilatation thermique (22) d'une feuille de dilatation thermique (20), le procédé d'impression comprenant :

   l'impression de la couche de conversion photo-thermique (41, 43) en utilisant une encre (10) sur au moins une surface de la feuille de dilatation thermique (20), l'encre (10) comprenant(i) un agent d'absorption infrarouge inorganique présentant un coefficient d'absorption dans au moins une zone d'un spectre de lumière infrarouge plus grand que dans le spectre de lumière visible, et (ii) une base qui est transparente à la lumière visible,
   **caractérisé en ce que** la couche de conversion photo-thermique (41, 43) est transparente à la lumière visible.

10. Procédé d'impression selon la revendication 9, le procédé d'impression étant un procédé d'impression à jet d'encre, de sérigraphie, d'héliogravure, d'impression offset ou d'impression par flexographie.

11. Système configuré pour fabriquer un objet façonné en utilisant une couche de conversion photo-thermique (41, 43) pour provoquer, en utilisant une unité de dilatation (53) la dilatation au moins une portion d'une couche de dilatation thermique (22) du feuille de dilatation thermique (20), le système comprenant :

   une unité d'impression (52) configurée pour former la couche de conversion photo-thermique (41, 43) en utilisant une encre (10) sur au moins une surface de la feuille de dilatation thermique (20), l'encre (10) comprenant(i) un agent d'absorption infrarouge inorganique présentant un coefficient d'absorption dans au moins une zone d'un spectre de lumière infrarouge plus grand que dans le spectre de lumière visible, et (ii) une base qui est transparente à la lumière visible, et
   une unité d'illumination configurée pour illuminer une face avant et/ou arrière de la feuille de dilatation thermique (20) avec de la lumière destinée à provoquer la dilatation d'au moins la portion de la couche de dilatation thermique (22),
**caractérisé en ce que** la couche de conversion photo-thermique (41, 43) est transparente à la lumière visible.

REGION B    REGION A

25(10)

20

FIG.1

FIG.2

FIG.3

FIG.4

50

54          55

DISPLAY UNIT

EXPANSION UNIT          PRINTING UNIT          52

53          61 } 60
             62

CONTROL UNIT          51

Z
X ← ⊙
      Y

**FIG.5A**

50

54          IMAGE          55

60

Z
X ← ⊙
      Y

**FIG.5B**

50

53  53a          52  52a          60

EXPANSION UNIT          PRINTING UNIT          TRANSPORT DIRECTION D

53b          52b

Z
X ← ⊙
      Y

**FIG.5C**

FIG.6

FIG.7

FIG.8A

FIG.8B

FIG.8C

FIG.8D

FIG.8E

PSEUDO-3D IMAGE
FORMATION PROCEDURE

S21

PRINT PHOTOTHERMAL CONVERSION LAYER
AND COLOR INK LAYER ON FRONT FACE OF
THERMALLY EXPANDABLE SHEET

S22

IRRADIATE FRONT FACE OF
THERMALLY EXPANDABLE SHEET

S23

PRINT PHOTOTHERMAL CONVERSION
LAYER ON BACK FACE OF
THERMALLY EXPANDABLE SHEET

S24

IRRADIATE BACK FACE OF
THERMALLY EXPANDABLE SHEET

END

FIG.9

FIG.10A

FIG.10B

FIG.10C

FIG.10D

FIG.11A

FIG.11B

FIG.12

FIG.13

**EP 3 378 663 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6428660 A
- JP 2001150812 A
- EP 1790701 A1
- US 2009115826 A1
- JP 2015117353 A
- EP 1008564 A1
- JP 2004168842 A
- EP 1954768 A1
- WO 2007132214 A1
- DE 102008049595 A1
- EP 0376322 A2
- US 5846622 A
- US 2013161874 A1